# EUROPEAN PATENT APPLICATION

(11) **EP 4 131 678 A2**
(43) Date of publication of application: **08.02.2023**
(21) Application number: 22187822.6
(22) Date of filing: 29.07.2022
(51) Int. Cl.: H01S 5/183, H01S 5/42, H01S 5/40, H01S 5/323, H01S 5/30

(54) **MULTI-WAVELENGTH LIGHT-EMITTING SEMICONDUCTOR DEVICES**

(30) Priority: 04.08.2021 GB 202111241
(71) Applicant: IQE plc, Cardiff CF3 0LW (GB)
(72) Inventor: Johnson, Andrew, Cardiff, CF3 0LW (GB)
(74) Representative: Yeomans, Victoria Jane Anora

(57) **Abstract**

A multi-wavelength light-emitting semiconductor device and a method of fabricating the same are disclosed. The semiconductor device includes a substrate, a first reflector on the substrate, a light emission layer on the first reflector, second reflectors on corresponding active regions; and apertures on corresponding active regions. The light emission layer includes active regions. Each of the active regions includes a primary emission wavelength different from each other.

## Description

### FIELD

The present disclosure generally relates to semiconductor devices, and in particular relates to light-emitting semiconductor devices, such as vertical cavity surface emitting lasers (VCSELs).

### BACKGROUND

Light-emitting semiconductor devices have a wide variety of applications in optical interconnection of integrated circuits, optical computing systems, optical recording and readout systems, telecommunications, three-dimensional sensing systems, and light detection and ranging (LiDAR) systems. Some of the light-emitting semiconductor devices used in such applications include vertical-cavity surface-emitting lasers (VCSELs), edge-emitting lasers, quantum-cascade lasers, and light emitting diodes.

VCSELs are a type of semiconductor laser diodes formed from a PN junction between a p-type material and an n-type material. The PN junction forms an active region. The active region can include a number of quantum wells. Free carriers in the form of holes and electrons are injected into the quantum wells, when the PN junction is forward biased by an electrical current. At a sufficient bias current, the injected minority carriers form a population inversion in the quantum wells that produce optical gain, which is used inside a resonant cavity to cause lasing in VCSELs.

### SUMMARY

The present disclosure provides example multi-wavelength light-emitting (MWLE) semiconductor devices with VCSEL arrays and methods of making the VCSEL arrays on the same substrate. In some embodiments, each of the VCSELs can have a primary emission wavelength different from each other. These MWLE VCSEL arrays can be used in three-dimensional sensing systems, such as facial recognition systems.

In some embodiments, a semiconductor device includes a substrate, a first reflector on the substrate, a light emission layer on the first reflector, second reflectors on corresponding active regions; and apertures on corresponding active regions. The light emission layer includes active regions. Each of the active regions includes a primary emission wavelength different from each other. Each of the apertures is surrounded by an oxidized oxidation layer. The semiconductor device with multi-wavelength light emitting active regions in the same light emission layer advantageously provides multi-wavelength light emission in closer proximity to each other than other MWLE devices formed by integrating different devices with different emission wavelengths. Advantages of the semiconductor device can include reduced manufacturing cost and improved alignment between the multi-wavelength light emission regions than other MWLE devices that require additional processes to align the integrated devices. The enhanced alignment can improve the device performance. Advantageously, the semiconductor device can be used in applications that require multi-wavelength light emission in close proximity to each other, such as facial recognition systems.

In some embodiments, the light emission layer includes a III-V compound semiconductor material, where group V materials of the III-V compound semiconductor material includes a nitrogen atom concentration between about 0 % and about 5 %. The nitrogen atom concentration range in the light emission layer can advantageously allow the energy bandgap of the III-V compound semiconductor material to be tuned to a smaller energy bandgap compared to III-V compound semiconductor materials without nitrogen atom or with nitrogen atom concentration above about 5 %. As a result, the III-V compound semiconductor material with the smaller energy bandgap advantageously allows the light emission layer to have a longer primary emission wavelength compared to light emission layers without nitrogen atom or with nitrogen atom concentration above about 5 %.

In some embodiments, the light emission layer includes a III-V compound semiconductor material, where group III materials of the III-V compound semiconductor material includes an indium atom concentration between about 0 % and about 20 %. The indium atom concentration range in the light emission layer can advantageously minimize lattice mismatch between the III-V compound semiconductor material and the material of the substrate.

In some embodiments, the light emission layer includes a gallium arsenide-based dilute nitride semiconductor material, an indium phosphide-based dilute nitride semiconductor material, or a gallium phosphide-based dilute nitride semiconductor material. The gallium arsenide-based dilute nitride semiconductor material includes gallium arsenide nitride (GaAsN), indium gallium arsenide nitride (InGaAsN), or aluminum gallium antimonide phosphide nitride (AlGaSbPN). The gallium arsenide-based dilute nitride semiconductor material, indium phosphide-based dilute nitride semiconductor material, or gallium phosphide-based dilute nitride semiconductor material of the light emission layer can advantageously allow the light emitting active regions of the light emission layer to be selectively tuned over a wide range of emission wavelengths ranging from about 1100 nm to about 1700 nm.

In some embodiments, the light emission layer includes gallium indium nitride arsenide antimonide (GaInNAsSb) with a nitrogen atom concentration between about 0 % and about 5 %, an indium atom concentration between about 0 % and about 20 %, and an antimony atom concentration between about 0 % and about 6 %. The GaInNAsSb material with such nitrogen atom concentration can advantageously allow the light emitting active regions of the light emission layer to be selectively tuned over a wide range of emission wavelengths ranging from about 1100 nm to about 1700 nm. The GalnNAsSb material with such indium atom concentration can advantageously minimize lattice mismatch between the GaInNAsSb material and the material of the substrate.

In some embodiments, the substrate includes a gallium arsenide-based material, an indium phosphide-based material, or a gallium phosphide-based material. The gallium arsenide-based material, indium phosphide-based material, or gallium phosphide-based material can advantageously allow high quality epitaxial layers to be grown on the substrate for the formation of the VCSEL arrays of the semiconductor device. In addition, the gallium arsenide-based material, indium phosphide-based material, or gallium phosphide-based material can advantageously minimize lattice mismatch with the material of the light emission layer.

In some embodiments, each of the second reflectors includes a stack of first and second semiconductor layers arranged in an alternating configuration, where the first and second semiconductor layers include n-type or p-type dopants. The first and second semiconductor layers include III-V compound semiconductor-based materials different from each other. The doped III-V compound semiconductor-based materials of the first and second semiconductor layers can advantageously allow high quality epitaxial layers with minimal lattice mismatch to be grown on the gallium arsenide-based dilute nitride semiconductor material, indium phosphide-based dilute nitride semiconductor material, or gallium phosphide-based dilute nitride semiconductor material of the light emission layer.

In some embodiments, the first reflector includes a stack of first and second semiconductor layers arranged in a first alternating configuration, where the first and second semiconductor layers include n-type or p-type dopants. Each of the second reflectors includes a stack of third and fourth semiconductor layers arranged in a second alternating configuration, and the third and fourth semiconductor layers include n-type or p-type dopants. The doped III-V compound semiconductor-based materials of the first and second semiconductor layers can advantageously allow high quality epitaxial layers with minimal lattice mismatch to be grown on the gallium arsenide-based material, indium phosphide-based material, or gallium phosphide-based material of the substrate. In addition, the doped III-V compound semiconductor-based materials of the third and fourth semiconductor layers can advantageously allow high quality epitaxial layers with minimal lattice mismatch to be grown on the gallium arsenide-based dilute nitride semiconductor material, indium phosphide-based dilute nitride semiconductor material, or gallium phosphide-based dilute nitride semiconductor material of the light emission layer.

In some embodiments, each of the second reflectors includes a stack of dielectric layers, where the stack of dielectric layers includes a metal oxide, a metal sulfide, a metal halide, an oxynitrides, or a combination thereof. The dielectric layers of the second reflectors can advantageously allow the second reflectors to be formed with a deposition process, instead of an epitaxial growth process. In addition, forming the second reflectors with dielectric layers do not require a doping process. As a result, the complexities and manufacturing costs of forming the second reflectors can be reduced.

In some embodiments, the semiconductor device further includes tunnel junction structures on corresponding active regions. The use of the tunnel junction structures can advantageously allow the first and second reflectors to be formed with similar conductivity type dopants.

In some embodiments, the semiconductor device further includes a tunnel junction structure on or below the light emission layer. The use of the tunnel junction structures can advantageously allow the first and second reflectors to be formed with similar conductivity type dopants.

In some embodiments, the semiconductor device further includes a tunnel junction structure on or below the apertures. The use of the tunnel junction structures can advantageously allow the first and second reflectors to be formed with similar conductivity type dopants.

In some embodiments, each of the apertures includes a III-V compound semiconductor material with an aluminum atom concentration between about 80 % and about 100 %. The aluminum atom concentration range can advantageously control the dimensions of the aperture.

In some embodiments, a difference between the primary emission wavelengths of first and second active regions of the active regions ranges from about 1 nm to about 200 nm. Such a wide range of difference between the primary emission wavelengths of the first and second active regions can advantageously allow the first and second active regions to be tuned within a wide range of primary emission wavelengths.

In some embodiments, the primary emission wavelength of each of the active regions is less than about 1700 nm. The use of active regions with primary emission wavelengths less than about 1700 nm can advantageously provide the semiconductor device with long wavelength VSCEL arrays that have a wide range of applications in optical communications and three-dimensional sensing systems.

In some embodiments, the semiconductor device further includes a passivation layer surrounding the second reflectors, where the passivation layer includes an oxide material, a nitride material, or a combination thereof. The passivation layer can advantageously protect the structural and compositional integrity of the second reflectors during the fabrication of the semiconductor device.

In some embodiments, the semiconductor device further includes insulating structures on corresponding second reflectors, where the insulating structures are substantially aligned with corresponding apertures. The insulating structures can advantageously allow the primary emission wavelengths of the active regions of the light emission layer to be selectively tuned during the fabrication of the semiconductor device. The selective tuning of the primary emission wavelengths of the active regions can advantageously provide the semiconductor device with multi-wavelength active regions.

In some embodiments, the semiconductor device further includes grating structures on corresponding second reflectors, where the grating structures have periodic patterns different from each other. The grating structures with different periodic patterns can advantageously allow the primary emission wavelengths of the active regions of the light emission layer to be selectively tuned during the fabrication of the semiconductor device to achieve multi-wavelength active regions. In addition, the grating structures with different periodic patterns can advantageously allow optical modulation of the VCSEL arrays of the semiconductor device.

In some embodiments, the semiconductor device further includes grating structures on corresponding second reflectors, where the grating structures include a polymeric material. The grating structures can advantageously allow the primary emission wavelengths of the active regions of the light emission layer to be selectively tuned during the fabrication of the semiconductor device to achieve multi-wavelength active regions. In addition, the grating structures can advantageously allow optical modulation of the VCSEL arrays of the semiconductor device. The polymeric material-based grating structures advantageously reduce the complexities and manufacturing costs of forming the grating structures.

In some embodiments, the semiconductor device further includes first contact structures disposed on corresponding second reflectors and second contact structures disposed on the substrate. The first and second contact structures can advantageously allow each of the VCSELs of the semiconductor device to be coupled to a corresponding readout circuit and to be addressed independently from each other.

In some embodiments, the semiconductor device further includes insulating structures disposed on the substrate and contact structures surrounding corresponding insulating structures. The insulating structures can advantageously allow the primary emission wavelengths of the active regions of the light emission layer to be selectively tuned during the fabrication of the semiconductor device to achieve multi-wavelength active regions.

In some embodiments, the semiconductor device further includes grating structures disposed on the substrate and contact structures surrounding corresponding grating structures. The grating structures can advantageously allow the primary emission wavelengths of the active regions of the light emission layer to be selectively tuned during the fabrication of the semiconductor device to achieve multi-wavelength active regions.

In some embodiments, a method includes forming a bottom reflector on a first side of a substrate, and forming a light emission layer with first and second active regions on the bottom reflector. The first and second active regions include an initial primary emission wavelength. The first and second active regions include the same initial primary emission wavelength. The method further includes forming first and second top reflectors on the first and second active regions, respectively, forming first and second apertures on the first and second active regions, respectively, and performing an anneal process on the first and second active regions to shift the initial primary emission wavelength to first and second primary emission wavelengths, respectively, where the first and second primary emission wavelengths are different from each other. Advantageously the method provides a process for forming a MWLE semiconductor device without an alignment process as required by other MWLE devices formed by integrating different devices with different emission wavelengths. The omission of the alignment process can improve the alignment between the multi-wavelength light emission regions, and consequently improve the device performance.

In some embodiments, performing the anneal process on the first and second active regions includes selectively annealing the first active region at a first annealing condition to shift the initial primary emission wavelength of the first active region to the first primary emission wavelength, and selectively annealing the second active region at a second annealing condition to shift the initial primary emission wavelength of the second active region to a second primary emission wavelength, where the first and second annealing conditions are different from each other. The selective annealing of the first and second active regions can advantageously tune the energy bandgap of the material of the first and second active regions and provide a process for forming a MWLE semiconductor device without an alignment process as required by other MWLE devices formed by integrating different devices with different emission wavelengths. The omission of the alignment process can improve the alignment between the multi-wavelength light emission regions, and consequently improve the device performance.

In some embodiments, the first and second annealing conditions include first and second annealing temperatures different from each other. The annealing of the first and second active regions at different temperatures can advantageously tune the energy bandgap of the material of the first and second active regions and provide a process for forming a MWLE semiconductor device without an alignment process as required by other MWLE devices formed by integrating different devices with different emission wavelengths.

In some embodiments, selectively annealing the first and second active regions includes performing a laser anneal process. The selective annealing of the first and second active regions can advantageously tune the energy bandgap of the material of the first and second active regions and provide a process for forming a MWLE semiconductor device without an alignment process as required by other MWLE devices formed by integrating different devices with different emission wavelengths. In addition, the laser anneal process can advantageously provide a focused anneal process to prevent or minimize thermal crosstalk between the first and second active regions during the selective annealing process.

In some embodiments, the method further includes forming first and second capping structures on the first and second top reflectors, where thicknesses of the first and second capping structures are different from each other. The first and second capping structures can advantageously allow the primary emission wavelengths of the active regions of the light emission layer to be selectively tuned during the fabrication of the semiconductor device to achieve multi-wavelength active regions.

In some embodiments, forming the first and second capping structures includes depositing a layer of polymeric material over the light emission layer and transferring a mold pattern on the layer of polymeric material. The first and second capping structures can advantageously allow the primary emission wavelengths of the active regions of the light emission layer to be selectively tuned during the fabrication of the semiconductor device to achieve multi-wavelength active regions. In addition, the use of a mold pattern and polymeric layer to form the first and second capping structures can advantageously reduce the complexities and manufacturing costs of forming the first and second capping structures.

In some embodiments, the method further includes forming first and second grating structures on the first and second top reflectors, where periodic patterns of the first and second grating structures are different from each other. The first and second grating structures can advantageously allow the primary emission wavelengths of the active regions of the light emission layer to be selectively tuned during the fabrication of the semiconductor device to achieve multi-wavelength active regions.

In some embodiments, forming the first and second grating structures includes depositing a layer of polymeric material over the light emission layer and transferring a mold pattern on the layer of polymeric material. The first and second grating structures can advantageously allow the primary emission wavelengths of the active regions of the light emission layer to be selectively tuned during the fabrication of the semiconductor device to achieve multi-wavelength active regions. In addition, the use of a mold pattern and polymeric layer to form the first and second grating structures can advantageously reduce the complexities and manufacturing costs of forming the first and second grating structures.

In some embodiments, the method further includes forming first and second capping structures on a second side of the substrate, where thicknesses of the first and second capping structures are different from each other. The first and second capping structures with different thicknesses can advantageously allow the primary emission wavelengths of the active regions of the light emission layer to be selectively tuned during the fabrication of the semiconductor device to achieve multi-wavelength active regions.

In some embodiments, the method further includes forming first and second grating structures on a second side of the substrate, where periodic patterns of the first and second grating structures are different from each other. The first and second grating structures with different periodic patterns can advantageously allow the primary emission wavelengths of the active regions of the light emission layer to be selectively tuned during the fabrication of the semiconductor device to achieve multi-wavelength active regions.

In some embodiments, forming the light emission layer includes epitaxially growing, on the bottom reflector, a dilute nitride semiconductor material with a nitrogen atom concentration between about 0 % and about 5 %. The nitrogen atom concentration range in the light emission layer can advantageously allow the energy bandgap of the III-V compound semiconductor material to be tuned to a smaller energy bandgap compared to III-V compound semiconductor materials without nitrogen atom or with nitrogen atom concentration above about 5 %. As a result, the III-V compound semiconductor material with the smaller energy bandgap advantageously allows the light emission layer to have a longer primary emission wavelength compared to light emission layers without nitrogen atom or with nitrogen atom concentration above about 5 %.

In some embodiments, the method further includes forming a passivation layer on the first and second top reflectors. The passivation layer can advantageously protect the structural and compositional integrity of the second reflectors during the fabrication of the semiconductor device.

In some embodiments, the method further includes forming first and second contacts on the first and second top reflectors, respectively. The first and second contact structures can advantageously allow each of the VCSELs of the semiconductor device to be coupled to a corresponding readout circuit and to be addressed independently from each other.

In some embodiments, the method further includes forming a first contact between the first top reflector and the first active region, and forming a second contact between the bottom reflector and the first active region. The first and second contacts include semiconductor materials. The formation of the first and second contacts of semiconductor material can advantageously allow the first contact to be epitaxially grown on the light emission layer and the second contact to be epitaxially grown on the bottom reflector.

### BRIEF DESCRIPTION OF THE DRAWINGS

Aspects of this disclosure are best understood from the following detailed description when read with the accompanying figures.
Figs. 1-5 illustrates cross-sectional views of MWLE semiconductor devices with VCSEL arrays, in accordance with some embodiments.
Fig. 6 is a flow diagram of a method for fabricating a MWLE semiconductor device with VCSEL arrays, in accordance with some embodiments.
Figs. 7-15 illustrate cross-sectional views of a MWLE semiconductor device with VCSEL arrays at various stages of its fabrication process, in accordance with some embodiments.
Fig. 16 is a flow diagram of a method for fabricating another MWLE semiconductor device with VCSEL arrays, in accordance with some embodiments.
Figs. 17-24 illustrate cross-sectional views of another MWLE semiconductor device with VCSEL arrays at various stages of its fabrication process, in accordance with some embodiments.
Fig. 25 is a flow diagram of a method for fabricating a MW back-emitting semiconductor device with VCSEL arrays, in accordance with some embodiments.
Figs. 26-32 illustrate cross-sectional views of a MW back-emitting semiconductor device with VCSEL arrays at various stages of its fabrication process, in accordance with some embodiments.
Fig. 33 illustrates a cross-sectional view of a MWLE semiconductor device with VCSEL arrays, in accordance with some embodiments.

Illustrative embodiments will now be described with reference to the accompanying drawings. In the drawings, like reference numerals generally indicate identical, functionally similar, and/or structurally similar elements. The discussion of elements with the same annotations applies to each other, unless mentioned otherwise.

### DETAILED DESCRIPTION

The following disclosure provides many different embodiments, or examples, for implementing different features of the provided subject matter. Specific examples of components and arrangements are described below to simplify the present disclosure. These are, of course, merely examples and are not intended to be limiting. For example, the process for forming a first feature over a second feature in the description that follows may include embodiments in which the first and second features are formed in direct contact, and may also include embodiments in which additional features may be formed between the first and second features, such that the first and second features may not be in direct contact. As used herein, the formation of a first feature on a second feature means the first feature is formed in direct contact with the second feature. In addition, the present disclosure may repeat reference numerals and/or letters in the various examples. This repetition does not in itself dictate a relationship between the embodiments and/or configurations discussed herein.

Spatially relative terms, such as "beneath," "below," "lower," "above," "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

It is noted that references in the specification to "one embodiment," "an embodiment," "an example embodiment," "exemplary," etc., indicate that the embodiment described may include a particular feature, structure, or characteristic, but every embodiment may not necessarily include the particular feature, structure, or characteristic. Moreover, such phrases do not necessarily refer to the same embodiment. Further, when a particular feature, structure or characteristic is described in connection with an embodiment, it would be within the knowledge of one skilled in the art to effect such feature, structure or characteristic in connection with other embodiments whether or not explicitly described.

It is to be understood that the phraseology or terminology herein is for the purpose of description and not of limitation, such that the terminology or phraseology of the present specification is to be interpreted by those skilled in relevant art(s) in light of the teachings herein.

In some embodiments, the terms "about" and "substantially" can indicate a value of a given quantity that varies within 5 % of the value (e.g., ±1 %, ±2 %, ±3 %, ±4 %, ±5 % of the value). These values are merely examples and are not intended to be limiting. The terms "about" and "substantially" can refer to a percentage of the values as interpreted by those skilled in relevant art(s) in light of the teachings herein.

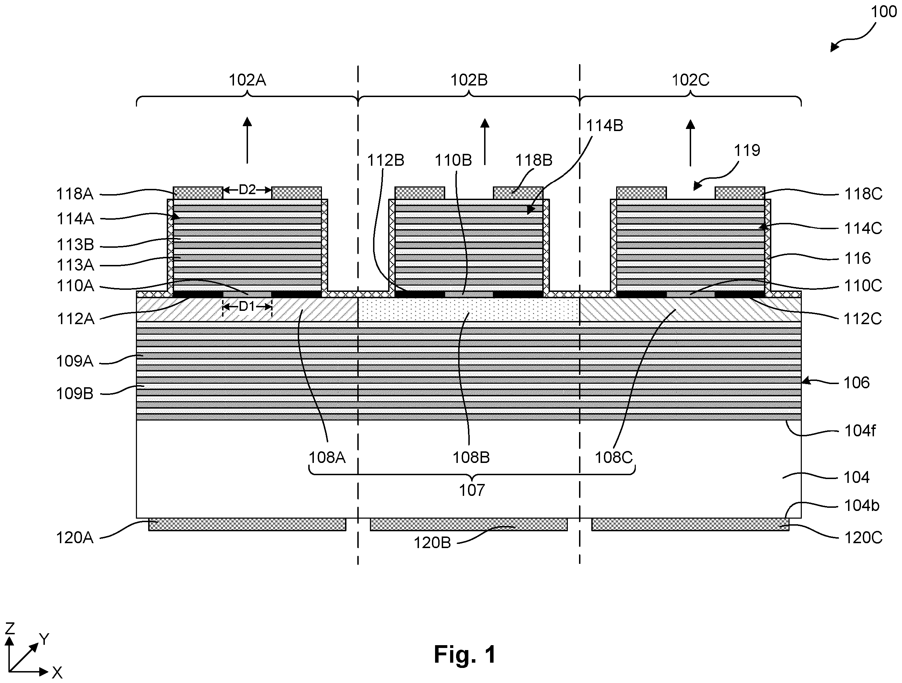

Fig. 1 illustrates a cross-sectional view of a MWLE semiconductor device with an array of top-emitting VCSELs 102A-102C, according to some embodiments. MWLE semiconductor device 100 can include a substrate 104 with a front side 104f and a back side 104b, a first reflector 106 on front side 104f, a light emission layer 107 with active regions 108A-108C on first reflector 106, apertures 110A-110C on light emission layer 107, oxidized oxidation layers 112A-112C surrounding apertures 110A-110C, second reflectors 114A-114C on oxidation layer 112A-112C, passivation layers 116 on sidewalls of second reflectors 114A-114C, first contacts 118A-118C on second reflectors 114A-114C, and second contacts 120A-120C on back side 104b of substrate 104.

In some embodiments, VCSEL 102A is formed by the following: active region 108A; aperture 110A; oxidation layer 112A; second reflector 114A; passivation layers 116 on sidewalls of second reflector 114A; first contact 118A; second contact 120A; and the portions of first reflector 106 and substrate 104 underlying active region 108A. Similarly, VCSEL 102B is formed by the following: active region 108B; aperture 110B; oxidation layer 112B; second reflector 114B; passivation layers 116 on sidewalls of second reflector 114B; first contact 118B; second contact 120B; and the portions of first reflector 106 and substrate 104 underlying active region 108B. And, VCSEL 102C is formed by the following: active region 108C; aperture 110C; oxidation layer 112C; second reflector 114C; passivation layers 116 on sidewalls of second reflector 114C; first contact 118C; second contact 120C; and the portions of first reflector 106 and substrate 104 underlying active region 108C. Though Fig. 1 shows three VCSELs 102A-102C arranged in a one-dimensional array, MWLE semiconductor device 100 can include any number of VCSELs similar to VCSELs 102A-102C arranged in one- or two-dimensional arrays.

Substrate 104 can be a semiconductor material, such as silicon (Si), germanium (Ge), silicon germanium (SiGe), gallium arsenide (GaAs), gallium phosphide (GaP), indium phosphide (InP), other suitable III-V compound semiconductor materials, diamond, compounds of group IV of the periodic table, and a combination thereof. In some embodiments, substrate 104 can include a stack of a Ge epitaxial layer on a Si layer, a stack of SiGe epitaxial layer on a Si layer, or other stacks of a semiconductor epitaxial layer on a Si layer, a GaAs layer, a GaP layer, an InP layer, or a diamond layer. In some embodiments, substrate 104 can be doped with n-type or p-type dopants. In some embodiments, substrate 104 can include GaAs with Si dopants. In some embodiments, substrate 104 can include GaAs with zinc (Zn) dopants.

First reflector 106 can be disposed on front side 104f of substrate 104. In some embodiments, first reflector 106 can include a conductive distributed Bragg reflector (DBR). First reflector 106 can include a stack of n-type or p-type semiconductor layers 109A-109B arranged in an alternating configuration. Semiconductor layers 109A-109B can have materials different from each other and refractive indices different from each other. In some embodiments, semiconductor layers 109A-109B can include epitaxially-grown materials or deposited materials. In some embodiments, semiconductor layers 109A-109B can include GaAs, aluminum gallium arsenide (AIGaAs), indium gallium arsenide (InGaAs), aluminum arsenide (AlAs), indium aluminum arsenide (InAIAs), other suitable III-V compound semiconductor materials, or a combination thereof. Semiconductor layers 109A-109B can include n-type or p-type dopants. In some embodiments, semiconductor layer 109A can include a III-V compound semiconductor material with a higher aluminum (Al) content (e.g., atomic concentration of Al atoms between about 80 % and about 99 %) and a lower refractive index than that of the III-V compound semiconductor material of semiconductor layer 109B, which can have an atomic concentration of Al atoms between about 5 % and about 20 %. In some embodiments, semiconductor layer 109A can include AIGaAs and semiconductor layer 109B can include GaAs. Both semiconductor layers 109A-109B can include Si, Ge, tellurium (Te), sulfur (S), or selenium (Se) dopants to form n-type semiconductor layers 109A-109B or can include carbon (C), beryllium (Be), magnesium (Mg), or zinc (Zn) dopants to form p-type semiconductor layers 109A-109B.

Similar to first reflector 106, each of second reflectors 114A-114C can include a conductive DBR. Second reflectors 114A-114C with first reflector 106 form the vertical cavities of VCSELs 102A-102C. Each of second reflectors 114A-114C can include a stack of p-type or-n-type semiconductor layers 113A-113B arranged in an alternating configuration. The discussion of semiconductor layers 109A-109B applies to semiconductor layers 113A-113B, unless mentioned otherwise. In some embodiments, semiconductor layer 113A can include AIGaAs and semiconductor layer 113B can include GaAs. Semiconductor layers 109A-109B can include C, Be, Mg, or Zn dopants to form p-type semiconductor layers 113A-113B or can include Si, Ge, Te, S, or Se dopants to form n-type semiconductor layers 113A-113B. In some embodiments, dimensions of each second reflectors 114A-114C along an X-axis and/or a Y-axis can be about 20 µm and dimensions of each second reflectors 114A-114C along a Z-axis can range between about 5 µm and about 20 µm. The growth direction of semiconductor layers 109A-109B and 113A-113B is along a Z-axis. The sidewalls of second reflectors 114A-114C can be covered by passivation layers 116 including an insulation material, such as oxides or nitrides to protect second reflectors 114A-114C from oxidation.

In some embodiments, instead of including a conductive DBR, each of second reflectors 114A-114C can include a non-conductive DBR. The non-conductive DBR can include a stack of two dielectric layers with different refractive indices arranged in an alternating configuration. The dielectric layers can include dielectric materials, such as magnesium fluoride, silicon oxide, tantalum pentoxide, zinc sulfide, titanium dioxide, aluminum oxide, silicon oxynitrides, cadmium sulfide, other suitable dielectric metal oxides, metal sulfides, metal halides, oxynitrides, or a combination thereof.

In some embodiments, light emission layer 107 can be disposed on first reflector 106. Light emission layer 107 can include one or more quantum well structures configured to emit light. The primary emission wavelength of the light emitted by light emission layer 107 can depend on the energy band gaps of the materials of the one or more quantum well structures. The one or more quantum well structures can be formed by one or more layers of dilute nitride materials included in light emission layer 107. The one or more layers of dilute nitride materials can include epitaxially-grown materials or deposited materials.

The one or more layers of dilute nitride materials can be substantially lattice matched to the material of substrate 104, according to some embodiments. In some embodiments, the dilute nitride materials can include a III-V compound semiconductor material with group III material(s) having about 50 % atomic concentration of the total atomic concentration of the III-V compound semiconductor material and group V material(s) having about 50 % atomic concentration of the total atomic concentration of the III-V compound semiconductor material. The group III material(s) of the dilute nitride material can include indium (In) atoms with an atomic concentration between about 0 % and about 20 % of the total atomic concentration of the group III material(s) for lattice matching the dilute nitride materials with the material (e.g., GaAs) of substrate 104. The group V material(s) of the dilute nitride material can include nitrogen atoms that have an atomic concentration between about 0 % and about 5 % of the total atomic concentration of the group V material(s). The atomic concentration of nitrogen atoms in the III-V compound semiconductor materials can reduce the energy band gaps of the III-V compound semiconductor materials and tune the emission wavelength of the dilute nitride materials to be longer than that of the III-V compound semiconductor materials without nitrogen atoms.

In some embodiments, light emission layer 107 can include a gallium arsenide-based dilute nitride material, an indium phosphide-based dilute nitride material, or a gallium phosphide-based dilute nitride material. In some embodiments, light emission layer 107 can include gallium arsenide nitride (GaAsN), indium gallium arsenide nitride (InGaAsN), gallium arsenide nitride antimonide (GaAsNSb), gallium indium nitride arsenide antimonide (GaInNAsSb), indium phosphide (InP), indium gallium arsenide (InGaAs), indium gallium arsenide nitride (InGaAsN), gallium arsenide antimonide (GaAsSb), indium gallium arsenide antimonide nitride (InGaAsSbN), gallium antimonide phosphide (GaSbP), gallium antimonide phosphide nitride (GaSbPN), indium gallium antimonide phosphide nitride (InGaSbPN), aluminum gallium antimonide phosphide nitride (AlGaSbPN), aluminum arsenide antimonide (AlAsSb), indium aluminum arsenide antimonide (InAIAsSb), indium aluminum arsenide antimonide nitride (InAIAsSbN), indium aluminum arsenide (InAIAs), indium aluminum arsenide antimonide (InAIAsSb), indium aluminum arsenide nitride (InAIAsN), indium aluminum arsenide nitride antimonide (InAIAsNSb), other suitable dilute nitride materials, or combinations thereof. In some embodiments, light emission layer 107 can include GaInNAsSb with a nitrogen atom concentration between about 0 % and about 5 %, an indium atom concentration between about 0 % and about 20 %, and an antimony atom concentration between about 0 % and about 6 %. In some embodiments, the thickness of light emission layer 107 can range from about 1 nm to about 20 nm. In some embodiments, light emission layer 107 can include multiple quantum well structures.

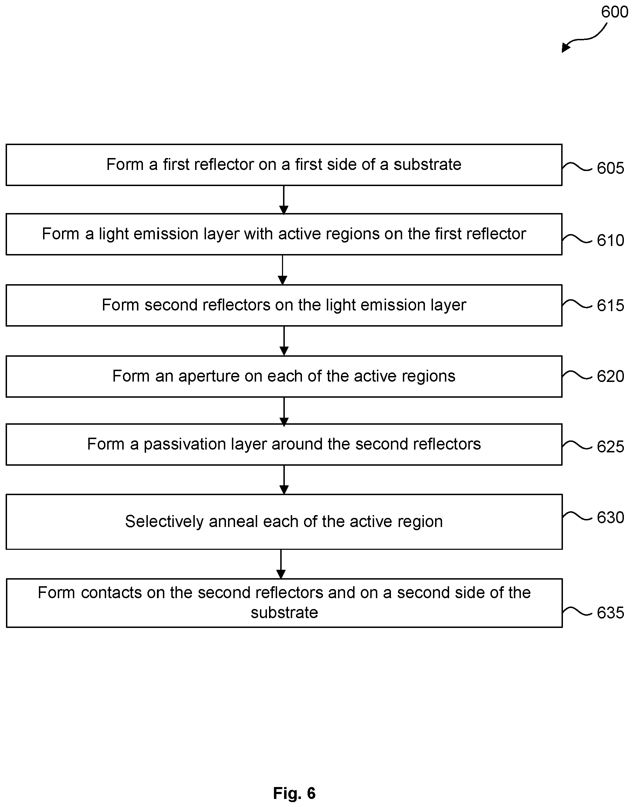

In some embodiments, light emission layer 107 includes active regions 108A-108C with primary emission wavelengths that are different from each other, and as a result, VCSELs 102A-102C emit light with primary emission wavelengths that are different from each other. The primary emission wavelengths of active regions 108A-108C are tuned to be different from each other by selectively processing each of active regions 108A-108C, which is described in detail below with reference to Figs. 6, 15, and 25. The selective processing (e.g., annealing) of active regions 108A-108C can selectively change the chemical structure (e.g., chemical bonding), and consequently selectively change the energy band gap of the material(s) included in the selectively processed region of light emission layer 107. In some embodiments, the primary emission wavelengths of active regions 108A-108C can be less than about 1700 nm. In some embodiments, the primary emission wavelengths of active regions 108A-108C can range between about 1100 nm and about 1700 nm. In some embodiments, differences between the primary emission wavelengths of active regions 108A-108C can range from about 1 nm to about 200 nm.

In some embodiments, apertures 110A-110C can be disposed on active regions 108A-108C, respectively. Apertures 110A-110C can confine the flow of drive current to active regions 108A-108C, respectively, and consequently define the shape and size of the emission window (e.g., define the diameter of a circular or cylindrical emission window) of active regions 108A-108C, respectively. In some embodiments, each of apertures 110A-110C can include an Al-based III-V compound semiconductor layer with a concentration of Al atoms between about 80 % and about 99 %. In some embodiments, each of apertures 110A-110C can include a layer of AIGaAs, AlAs, InAIAs, AlGaSbP, AlAsSb, InAIAsSb, InAIAsSb, other suitable Al-based III-V compound semiconductor materials, or combinations thereof. In some embodiments, the Al-based III-V compound semiconductor layer includes an epitaxially-grown material or a deposited material.

In some embodiments, each of apertures 110A-110C can have a thickness along a Z-axis between about 5 nm and about 50 nm. In some embodiments, each of apertures 110A-110C can have a thickness along a Z-axis between about 10 nm and about 20 nm. In some embodiments, each of apertures 110A-110C can have a dimension D1 (e.g., width or diameter) along an X-axis between about 8 µm and about 12 um. The dimensions of apertures 110A-110C along an X-axis can be defined by the lateral dimensions of oxidation layers 112A-112C surrounding apertures 110A-110C, respectively. Oxidation layers 112A-112C can include an oxide of the Al-based III-V compound semiconductor material of apertures 110A-110C. The oxide material of oxidation layers 112A-112C blocks the flow of drive current to the portions of active regions 108A-108C underlying oxidation layers 112A-112C. The oxide material also funnels the flow of drive current, and consequently increases current density. In addition, the oxide material blocks light emission from light emission layer 107 and focuses the light emission through apertures 110A-110C. In some embodiments, oxidation layers 112A-112C can have a thickness along a Z-axis substantially equal to the thickness of apertures 110A-110C.

In some embodiments, first contacts 118A-118C can be disposed on second reflectors 114A-114C, respectively, to inject charge carriers into second reflectors 114A-114C and can include a conductive material. For a top-emitting configuration of VCSELs 102A-102C, each of first contacts 118A-118C can include an opening 119 that is aligned to a corresponding one of apertures 110A-110C to allow emission of light from active regions 108A-108C through second reflectors 114A-114C. Each opening 119 can have a dimension D2 (e.g., width or diameter) along an X-axis that is substantially equal to or greater than dimension D1 of apertures 110A-110C. In some embodiments, first contacts 118A-118C can have annular-shaped structures.

In some embodiments, second contacts 120A-120C can be disposed on back-side 104b of substrate 104 to inject charge carriers into first reflector 106 and can include a conductive material. For a top-emitting configuration of VCSELs 102A-102C, each of second contacts 120A-120C is formed as a continuous layer on each of the portions of substrate 104 corresponding to VCSELs 102A-102C, as shown in Fig. 1. For a bottom-emitting configuration of VCSELs 102A-102C (not shown), each of first contacts 118A-118C can be formed as a continuous layer, instead of an annular-shaped structure, on second reflectors 114A-114C, respectively, and second contacts 120A-120C can be formed with openings 119 that are aligned to apertures 110A-110C to allow emission of light from active regions 108A-108C through substrate 104.

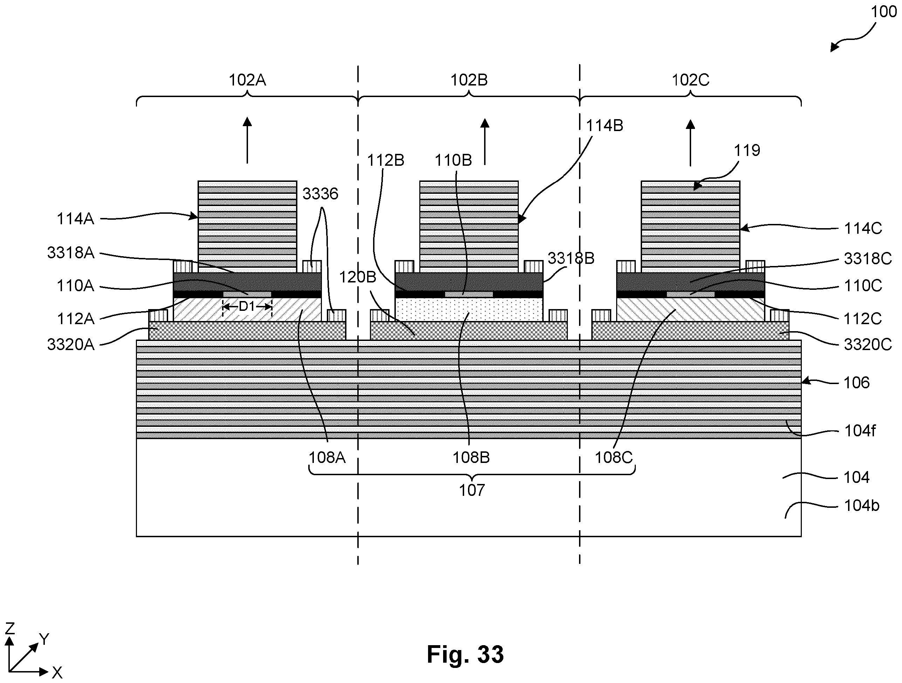

In some embodiments, instead of first contacts 118A-118C on second reflectors 114A-114C, VCSELs 102A-102C can have first contacts 3318A-3318C between second reflectors 114A-114C and active regions 108A-108C, as shown in Fig. 33. In some embodiments, instead of second contacts 120A-120C on substrate 104, VCSELs 102A-102C can have second contacts 3320A-3320C between first reflector 106 and active regions 108A-108C, as shown in Fig. 33. First contacts 3318A-3318C can include a p-type semiconductor material layer, such as a p-type GaAs layer, and second contacts 3320A-3320C can include an n-type semiconductor layer, such as n-type GaAs layer. The n-type and p-type semiconductor layers can be epitaxially-grown layers. VCSELs 102A-102C can further include metal leads 3336 on first contacts 3318A-3318C and second contacts 3320A-3320C, as shown in Fig. 33. Alternatively first contacts 3318A-3318C can be on second reflectors 114A-114C and second contacts 3320A-3320C can be between first reflector 106 and active regions 108A-108C or the first contacts 3318A-3318C can be between the second reflector 114A-114C and active regions 108A-108C and the second contacts 3320A-3320C can be on the substrate 104.

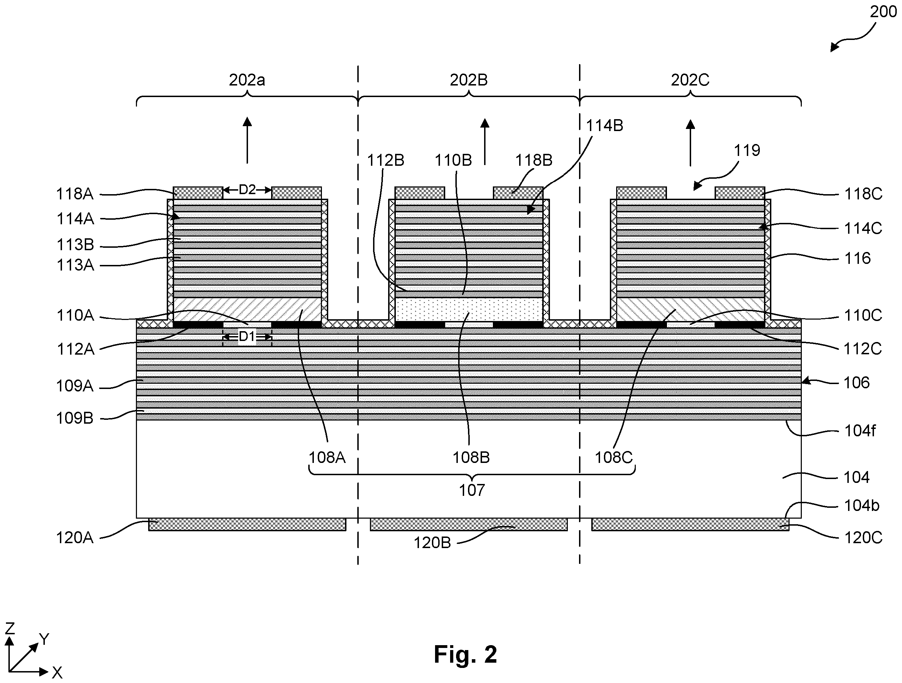

Fig. 2 illustrates a cross-sectional view of a MWLE semiconductor device 200 with an array of top-emitting VCSELs 202A-202C, according to some embodiments. The discussion of MWLE semiconductor device 100 applies to MWLE semiconductor device 200, unless mentioned otherwise. The discussion of elements in Figs. 1-2 with the same annotations applies to each other, unless mentioned otherwise. In some embodiments, apertures 110A-110C and surrounding oxidized oxidation layers 112A-112C can be disposed between active regions 108A-18C and first reflector 106, as shown in Fig. 2, instead of being disposed between active regions 108A-108C and second reflectors 114A-114C, as shown in Fig. 1.

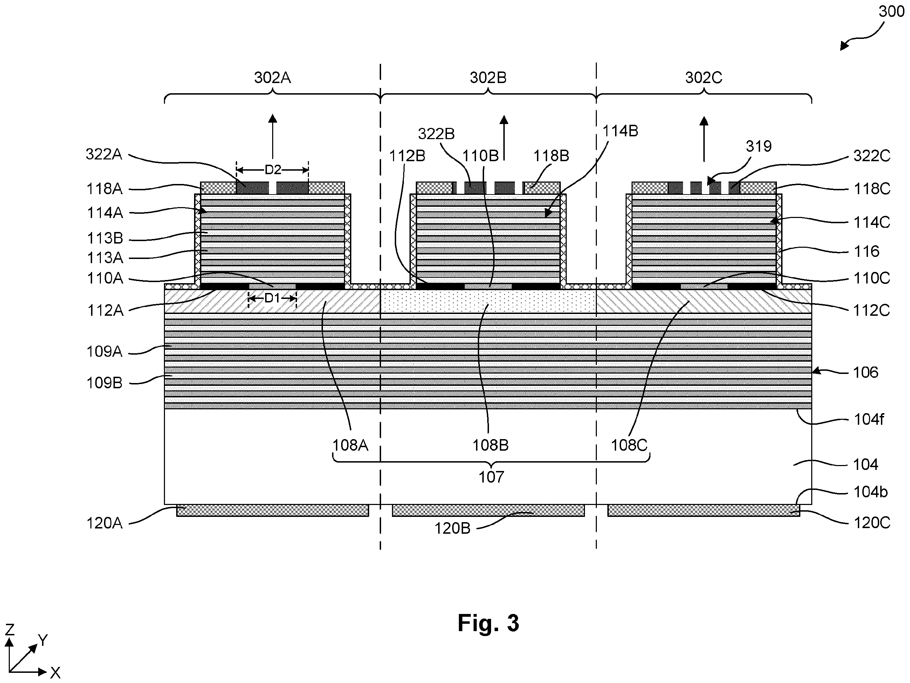

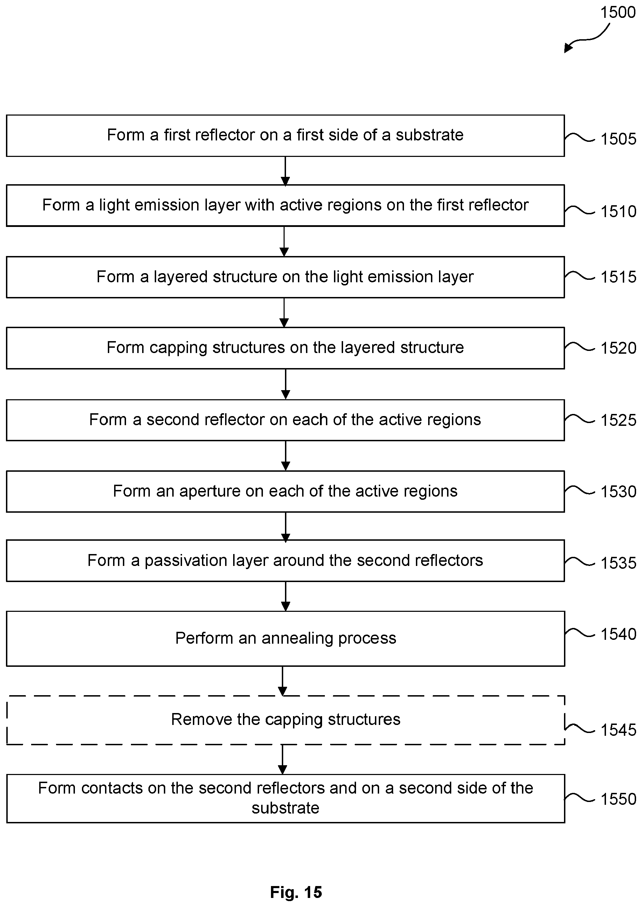

Fig. 3 illustrates a cross-sectional view of a MWLE semiconductor device 300 with an array of top-emitting VCSELs 302A-302C, according to some embodiments. The discussion of MWLE semiconductor device 100 applies to MWLE semiconductor device 300, unless mentioned otherwise. The discussion of elements in Figs. 1 and 3 with the same annotations applies to each other, unless mentioned otherwise. In some embodiments, VCSELs 302A-302C can include grating structures 322A-322C disposed within openings of first contacts 118A-118C. Grating structures 322A-322C can have periodic patterns that are different from each other along an X-axis, a Y-axis, and/or a Z-axis and can have thicknesses that vary from each other along a Z-axis. Grating structures 322A-322C can be used to tune the primary emission wavelength of light emitting from active regions 108A-108C through second reflectors 114A-114C. Grating structures 322A-322C can also be used for selective processing of active regions 108A-108C, as described in detail below with reference to Fig. 15. In some embodiments, grating structures 322A-322C can include polymeric materials.

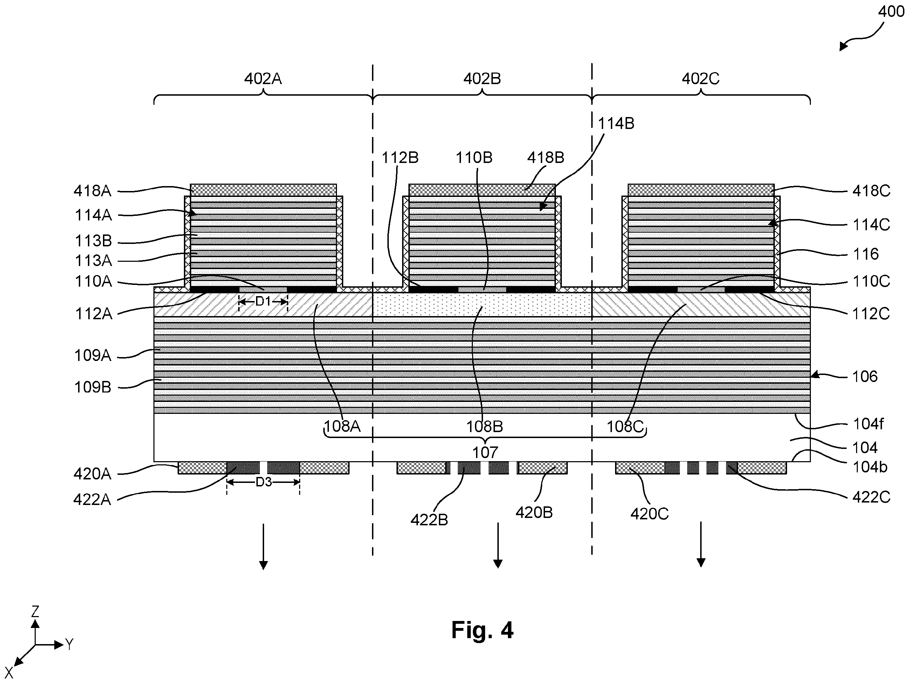

Fig. 4 illustrates a cross-sectional view of a MWLE semiconductor device 400 with an array of back-emitting VCSELs 402A-402C, according to some embodiments. The discussion of MWLE semiconductor device 100 applies to MWLE semiconductor device 400, unless mentioned otherwise. The discussion of elements in Figs. 1 and 4 with the same annotations applies to each other, unless mentioned otherwise.

In some embodiments, first contacts 418A-418C can be disposed on second reflectors 114A-114C, respectively, and can include a conductive material. For a back-emitting configuration of VCSELs 402A-402C, each of first contacts 418A-418C are formed as continuous layers on second reflectors 114A-114C, respectively.

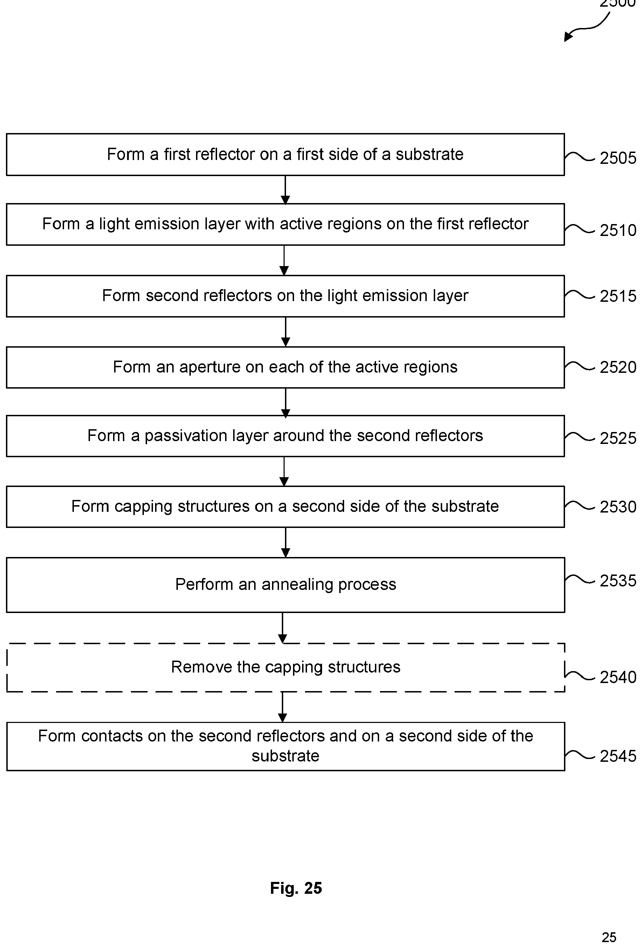

In some embodiments, second contacts 420A-420C can be disposed on back-side 104b of substrate 104 and can include a conductive material. For a back-emitting configuration of VCSELs 402A-402C, second contacts 420A-420C can include openings (not labelled), in which grating structures 422A-422C are disposed. Grating structures 422A-422C are aligned to corresponding apertures 110A-110C to allow emission of light from active regions 108A-108C through substrate 104. The openings can have dimensions D3 (e.g., width or diameter) along an X-axis that is substantially equal to or greater than dimension D1 of apertures 110A-110C. In some embodiments, second contacts 420A-420C can have annular-shaped structures. Grating structures 422A-422C can have periodic patterns that are different from each other along an X-axis, a Y-axis, and/or a Z-axis and can have thicknesses that vary from each other along a Z-axis. Grating structures 422A-422C can be used to tune the primary emission wavelength of light emitting from active regions 108A-108C through substrate 104. Grating structures 422A-422C can also be used for selective processing of active regions 108A-108C, as described in detail below with reference to Fig. 25. In some embodiments, grating structures 422A-422C can include polymeric materials.

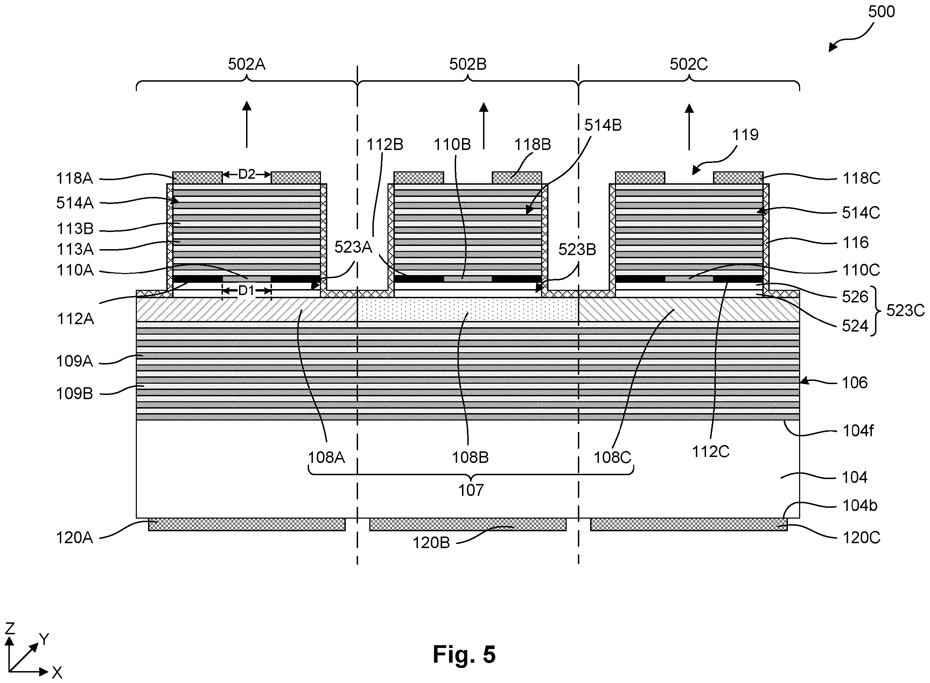

Fig. 5 illustrates a cross-sectional view of a MWLE semiconductor device 500 with an array of top-emitting VCSELs 502A-502C, according to some embodiments. The discussion of MWLE semiconductor device 100 applies to MWLE semiconductor device 500, unless mentioned otherwise. The discussion of elements in Figs. 1 and 5 with the same annotations applies to each other, unless mentioned otherwise.

In some embodiments, VCSELs 502A-502C can include tunnel junction structures 523A-523C disposed between apertures 110A-110C and active regions 108A-108C. In some embodiments, instead of being disposed between apertures 110A-110C and active regions 108A-108C, tunnel junction structures 523A-523C can be disposed between apertures 110A-110C and second reflectors 514A-514C (not shown). In some embodiments, instead of being disposed between apertures 110A-110C and active regions 108A-108C, tunnel junction structures 523A-523C can be disposed between apertures 110A-110C and first reflectors 106 of Fig. 2 (not shown). Each of tunnel junction structures 523A-523C can include an n-type semiconductor layer 524, a p-type semiconductor layer 526, and a tunnel junction at the interface between n-type semiconductor layer 524 and p-type semiconductor layer 526. In some embodiments, each of semiconductor layers 524 and 526 can have a thickness of about 5 nm to about 50 nm. In some embodiments, each of semiconductor layers 524 and 526 can have a thickness of about 10 nm to about 20 nm. Each of tunnel junction structures 523A-523C acts as an ohmic contact within VCSELs 502A-502C that allows the conductivity type of first reflector 106 or second reflectors 514A-514C to be reversed, so that the materials of first reflector 106 or second reflectors 514A-514C are non-absorbing at the emitting wavelength of VCSELs 502A-502C. Thus, the use of tunnel junction structures 523A-523B can allow second reflectors 514A-514C to be n-type conductivity, instead of p-type conductivity of second reflectors 114A-114C discussed above in Figs. 1-4. The discussion of second reflectors 114A-114C applies to second reflectors 514A-514C, except semiconductor layer 113A-113B of second reflectors 514A-514C include n-type dopants. In some embodiments, similar to VCSELs 302A-302C, grating structures 322A-322C can be included in VCSELs 502A-502C. In some embodiments, similar to VCSELs 402A-402C, first contacts 418A-418C and second contacts 420A-420C with grating structures 422A-422C can be incorporated in VCSELs 502A-502C to form back-emitting VCSELs 502A-502C.

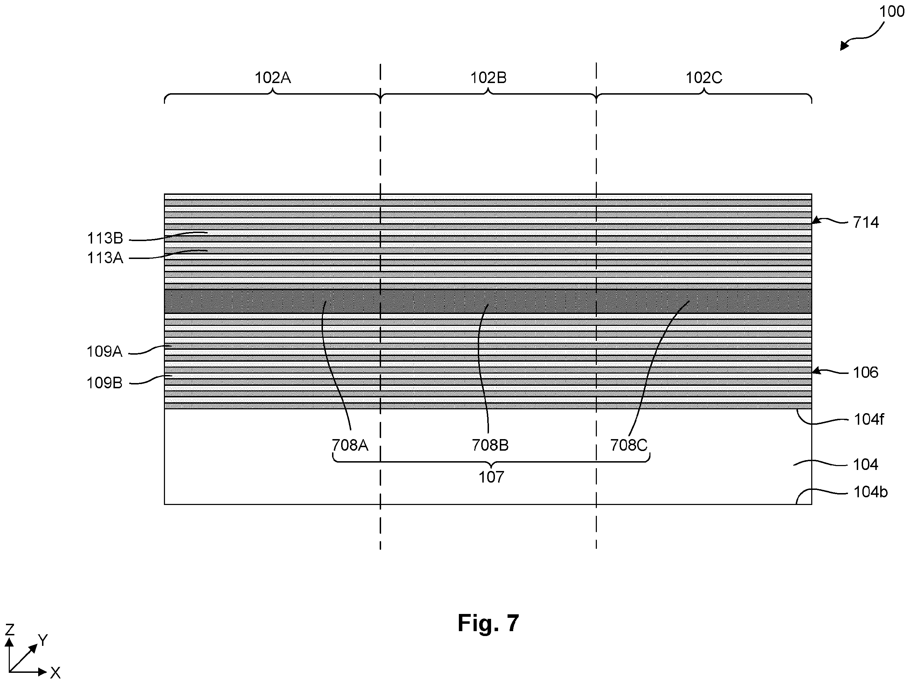

Fig. 6 is a flow diagram of an example method 600 for fabricating MWLE semiconductor device 100 with an array of top-emitting VCSELs 102A-102C shown in Fig. 1, according to some embodiments. For illustrative purposes, the operations illustrated in Fig. 6 will be described with reference to the example fabrication process for fabricating MWLE semiconductor device 100 as illustrated in Figs. 7-14. Figs. 7-14 are cross-sectional views of MWLE semiconductor device 100 at various stages of fabrication, according to some embodiments. Operations can be performed in a different order or not performed depending on specific applications. It should be noted that method 600 may not produce a complete MWLE semiconductor device 100. Accordingly, it is understood that additional processes can be provided before, during, and after method 600, and that some other processes may only be briefly described herein. Elements in Figs. 7-14 with the same annotations as elements in Fig. 1 are described above.

In operation 605, a first reflector is formed on a first side of a substrate. For example, as shown in Fig. 7, first reflector 106 is formed on front side 104f of substrate 104. In some embodiments, the formation of first reflector 106 can include epitaxially growing semiconductor layers 109A-109B in an alternating configuration on substrate 104 and doping semiconductor layers 109A-109B with n-type or p-type dopants. In some embodiments, epitaxially growing semiconductor layers 109A-109B can include epitaxially growing GaAs, AIGaAs, InGaAs, AlAs, InAIAs, other suitable III-V compound semiconductor materials, or a combination thereof. In some embodiments, the formation of first reflector 106 can include epitaxially growing AIGaAs and GaAs in an alternating configuration and doping with Si, Ge, Te, S, or Se dopants to form n-type first reflector 106 or doping with C, Be, Mg, or Zn dopants to form p-type first reflector 106.

Referring to Fig. 6, in operation 610, a light emission layer with active regions is formed on the first reflector. For example, as shown in Fig. 7, light emission layer 107 with active regions 708A-708C is formed on first reflector 106. Active regions 708A-708C can have the same initial primary emission wavelength and can be selectively processed in subsequent operations to form active regions 108A-108C with primary emission wavelengths different from each other. In some embodiments, the formation of light emission layer 107 with active regions 708A-708C can include epitaxially growing one or more layers of dilute nitride materials. In some embodiments, the dilute nitride materials can be epitaxially grown with In atoms having an atomic concentration between about 0 % and about 20 %. In some embodiments, the dilute nitride materials can be epitaxially grown by epitaxially growing III-V compound semiconductor materials with nitrogen atoms that have an atomic concentration between about 0 % and about 5 %. In some embodiments, the formation of light emission layer 107 with active regions 708A-708C can include epitaxially growing one or more layers of gallium arsenide-based dilute nitride material, indium phosphide-based dilute nitride material, or gallium phosphide-based dilute nitride material. In some embodiments, the formation of light emission layer 107 with active regions 708A-708C can include epitaxially growing one or more layers of GaAsN, InGaAsN, GaAsNSb, GaInNAsSb, InP, InGaAs, InGaAsN, GaAsSb, InGaAsSbN, GaSbP, GaSbPN, InGaSbPN, AlGaSbPN, AlAsSb, InAIAsSb, InAIAsSbN, InAIAs, InAIAsSb, InAIAsN, InAIAsNSb, other suitable dilute nitride materials, or combinations thereof. In some embodiments, the formation of light emission layer 107 with active regions 708A-708C can include epitaxially growing one or more layers GaInNAsSb with a nitrogen atom concentration between about 0 % and about 5 %, an indium atom concentration between about 0 % and about 20 %, and an antimony atom concentration between about 0 % and about 6 %.

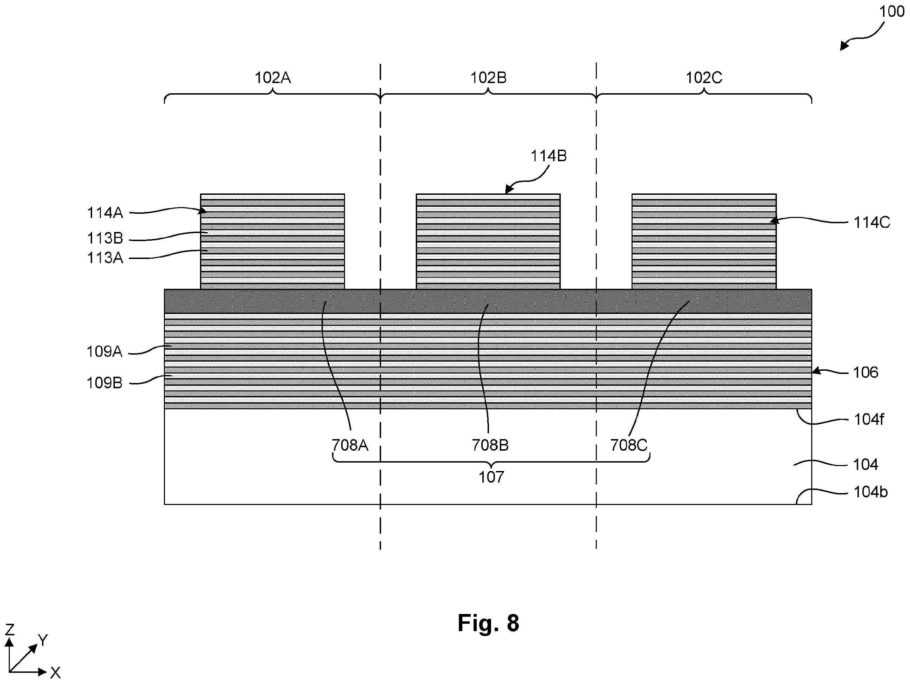

Referring to Fig. 6, in operation 615, second reflectors are formed on the light emission layer. For example, as described with reference to Figs. 7-8, second reflectors 114A-114C are formed on active regions 708A-708C, respectively, of light emission layer 107. The formation of second reflectors 114A-114C can include sequential operations of (i) epitaxially growing semiconductor layers 113A-113B in an alternating configuration on light emission layer 107 and doping semiconductor layers 113A-113B with n-type or p-type dopants during the epitaxial growth to form a layered structure 714, as shown in Fig. 7, (ii) forming a patterned photoresist layer (not shown) on doped semiconductor layers 113A-113B using a lithography process, (iii) etching doped semiconductor layers 113A-113B through openings in the patterned photoresist layer to form the mesa structures for second reflectors 114A-114C, as shown in Fig. 8, and (iv) removing the patterned photoresist layer. In some embodiments, epitaxially growing semiconductor layers 113A-113B can include epitaxially growing GaAs, AIGaAs, InGaAs, AlAs, InAIAs, other suitable III-V compound semiconductor materials, or a combination thereof. In some embodiments, epitaxially growing semiconductor layers 113A-113B can include epitaxially growing AIGaAs and GaAs. In some embodiments, doping semiconductor layers 113A-113B with p-type dopants can include doping with C, Be, Mg, or Zn dopants and with n-type dopants can include doping with Si, Ge, Te, S, or Se dopants. In some embodiments, semiconductor layer 113A that is directly on active regions 708A-708C can be epitaxially grown with a concentration of Al atoms between about 80 % and about 100 %, which is processed in subsequent operations to form apertures 110A-110C.

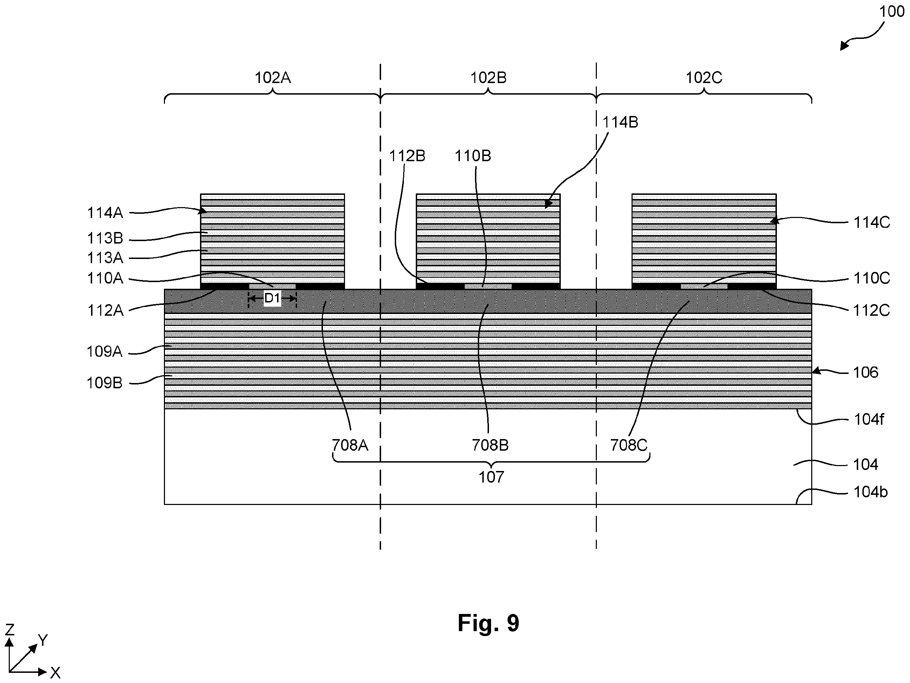

Referring to Fig. 6, in operation 620, an aperture is formed on each of the active regions. For example, as shown in Fig. 9, apertures 110A-110C are formed on active regions 708A-708C, respectively. The formation of apertures 110A-110C can include performing an oxidation process on the structure of Fig. 8. Semiconductor layers 113A that are directly on active regions 708A-708C and have a concentration of Al atoms between about 80 % and about 100 % can laterally oxidize along an X-axis faster than the other semiconductor layers 113A-113B in the structure of Fig. 8. The lateral oxidation process can include exposing the structure of Fig. 8 to steam. The unoxidized portions of semiconductor layers 113A that are directly on active regions 708A-708C form apertures 110A-110C.

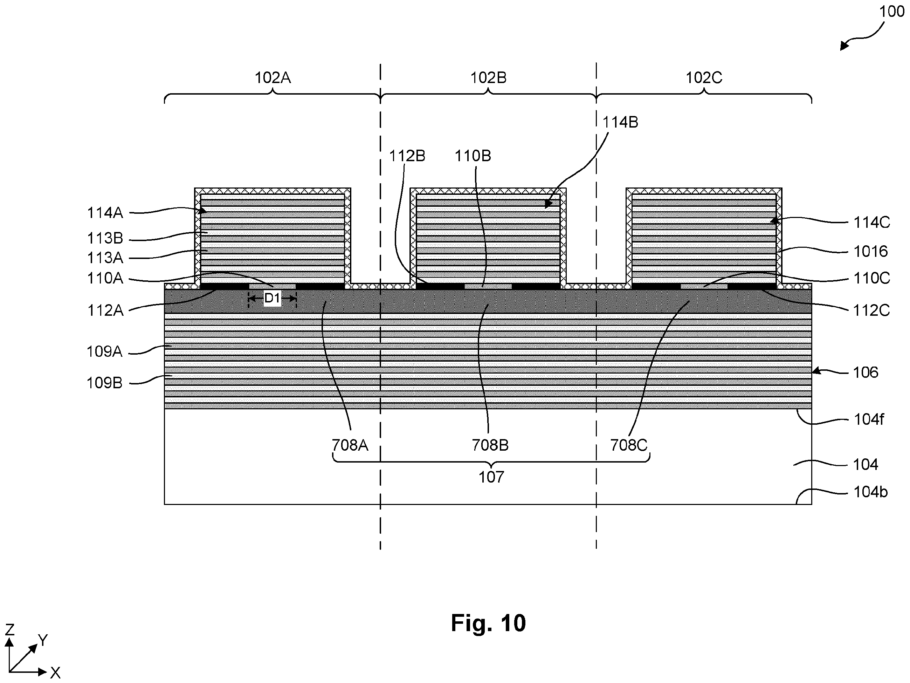

Referring to Fig. 6, in operation 625, a passivation layer is formed around the second reflectors. For example, as shown in Fig. 10, a passivation layer 1016 is formed on second reflectors 114A-114C. The formation of passivation layer 1016 can include depositing an oxide or nitride material layer on the structure of Fig. 9 using a chemical vapor deposition (CVD) process, an atomic layer deposition (ALD) process, or other suitable deposition processes for oxide and/or nitride materials.

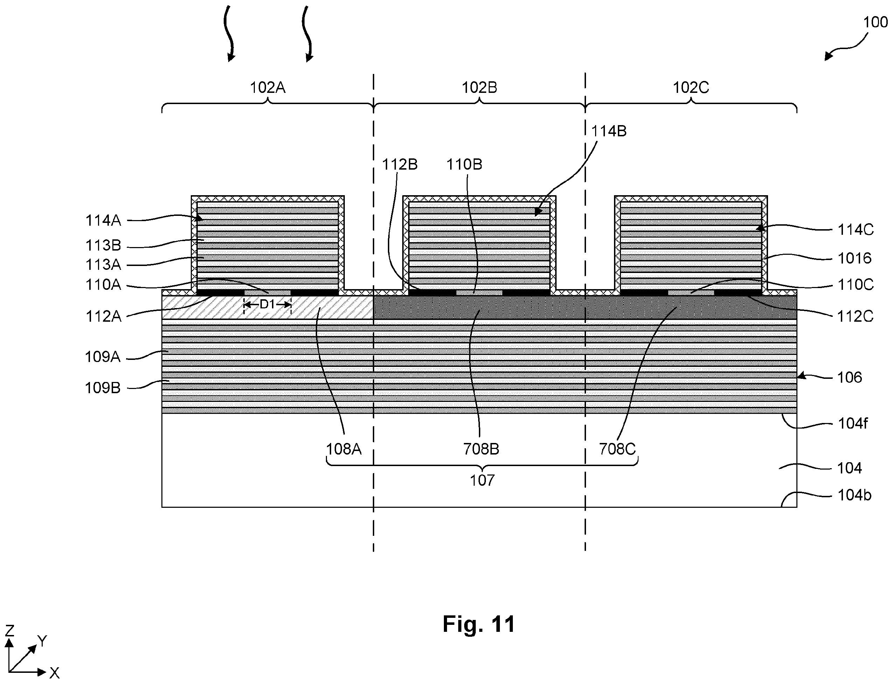

Referring to Fig. 6, in operation 630, each of the active regions are selectively annealed. For example, as described with reference to Figs. 11-13, active regions 708A-708C are selectively annealed to form active regions 108A-108C. As shown in Fig. 11, active region 708A can be selectively annealed using a localized annealing process, such as a laser anneal process with a first set of annealing conditions. The selective anneal process can blue shift (i.e., move from a longer wavelength to a shorter wavelength) the initial primary emission wavelength of active region 708A to a first primary emission wavelength of active region 108A that is shorter than the initial primary emission wavelength. The blue shift of the primary emission wavelengths can be due to the change in energy band gap of the material(s) within active region 708A during the selective anneal process.

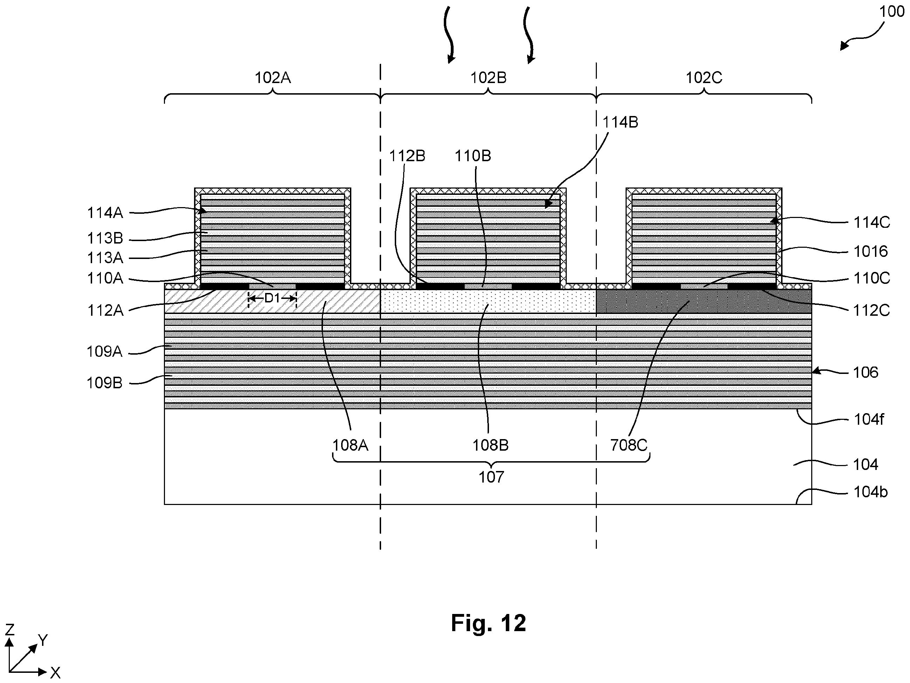

Following the selective anneal of active region 708A, as shown in Fig. 12, active region 708B can be selectively annealed using the localized annealing process, such the laser anneal process with a second set of annealing conditions that is different from the first set of annealing conditions. The selective anneal process with the second set of annealing conditions can blue shift the initial primary emission wavelength of active region 708B to a second primary emission wavelength of active region 108B that is shorter than the initial primary emission wavelength and different from the first primary emission wavelength of active region 108A.

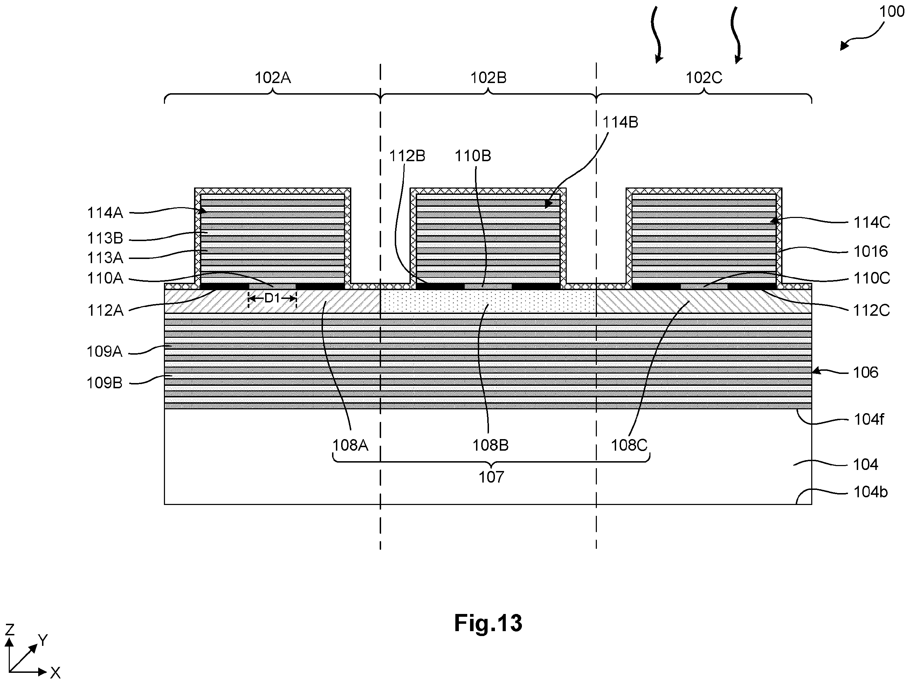

Following the selective anneal of active region 708B, as shown in Fig. 13, active region 708C can be selectively annealed using the localized annealing process, such the laser anneal process with a third set of annealing conditions that is different from the first and/or second sets of annealing conditions. In some embodiments, the first, second, and third sets of annealing conditions can be different from each other, or any one of the first, second, and third sets of annealing conditions can be different from the other two same sets of annealing conditions. The selective anneal process with the third set of annealing conditions can blue shift the initial primary emission wavelength of active region 708C to a third primary emission wavelength of active region 108C that is shorter than the initial primary emission wavelength and different from the first and second primary emission wavelengths of active regions 108A and 108B.

In some embodiments, one or more of the annealing conditions (e.g., temperature, duration, etc.) can be different between the first, second, and third sets of annealing conditions. In some embodiments, the annealing temperature can be the same (e.g., about 600°C) in the first, second, and third sets of annealing conditions, and the annealing duration can be different from each other in the first, second, and third sets of annealing conditions. In some embodiments, the laser spot size used in the laser anneal process can range between about 10 µm and 20 µm. Though the selective annealing of active regions 708A-708C is illustrated as being performed in the order of active region array, the selective annealing can be performed in any order. For example, active region 708C can be selectively annealed after active region 708A. And, active region 708B can be selectively annealed after active region 708C.

In some embodiments, the annealing process can be performed on back side 104b of substrate 104, instead of performing on the front side of the structure, as shown in Figs. 11-13.

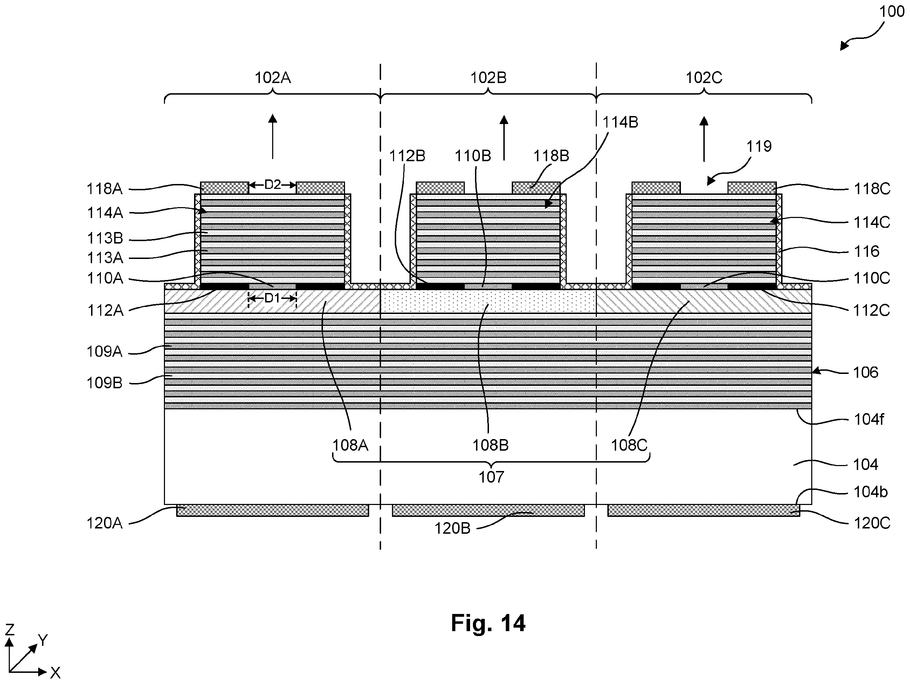

Referring to Fig. 6, in operation 635, contacts are formed on the second reflectors and on a second side of the substrate. For example, as shown in Fig. 14, first contacts 118A-118C are formed as annular-shaped electrical contacts on second reflectors 114A-114C with openings 119 aligned with apertures 110A-110C. Second contacts 120A-120C are formed as electrical contacts on back side 104b of substrate 104 and are formed aligned with second reflectors 114A-114C, respectively, as shown in Fig. 14. In some embodiments, first contacts 118A-118C and second contacts 120A-120C are formed from a low resistive metal, such as gold and other suitable metals.

In some embodiments, operation 635 may not be performed if first contacts 3318A-3318C are formed between second reflectors 114A-114C and active regions 108A-108C-rather than first contacts 118A-118C being formed on second reflectors 114A-114C, as shown in Fig. 33. Further, if second contacts 3320A-3320C are formed between first reflector 106 and active regions 108A-108C-rather than second contacts 120A-120C being formed on substrate 104, as shown in Fig. 33. In some embodiments, the formation of first contacts 3318A-3318C can include epitaxially growing a p-type semiconductor material layer, such as a p-type GaAs layer, on first reflector 106 in operation 605, and/or the formation of second contacts 3320A-3320C can include epitaxially growing an n-type semiconductor layer, such as n-type GaAs layer, on light emission layer 107 in operation 610.

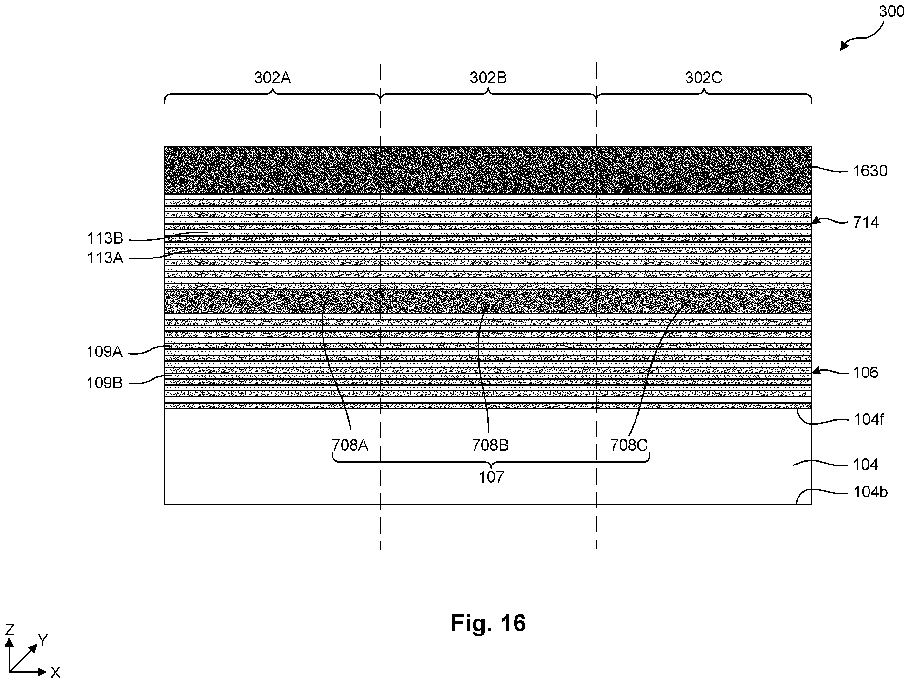

Fig. 15 is a flow diagram of an example method 1500 for fabricating MWLE semiconductor device 300 with an array of top-emitting VCSELs 302A-302C shown in Fig. 3, according to some embodiments. For illustrative purposes, the operations illustrated in Fig. 15 will be described with reference to the example fabrication process for fabricating MWLE semiconductor device 300 as illustrated in Figs. 16-24. Figs. 16-24 are cross-sectional views of MWLE semiconductor device 300 at various stages of fabrication, according to some embodiments. Operations can be performed in a different order or not performed depending on specific applications. It should be noted that method 1500 may not produce a complete MWLE semiconductor device 300. Accordingly, it is understood that additional processes can be provided before, during, and after method 1500, and that some other processes may only be briefly described herein. Elements in Figs. 16-24 with the same annotations as elements in Figs. 1, 3, and 7-14 are described above.

Referring to Fig. 15, operations 1505-1510 are similar to operations 605-610 of Fig. 6, respectively.

Referring to Fig. 15, in operation 1515, a layered structure is formed on the light emission layer. For example, as shown in Fig. 16, layered structure 714 is formed on light emission layer 107. The formation of layered structure 714 is similar to that described in operation 615.

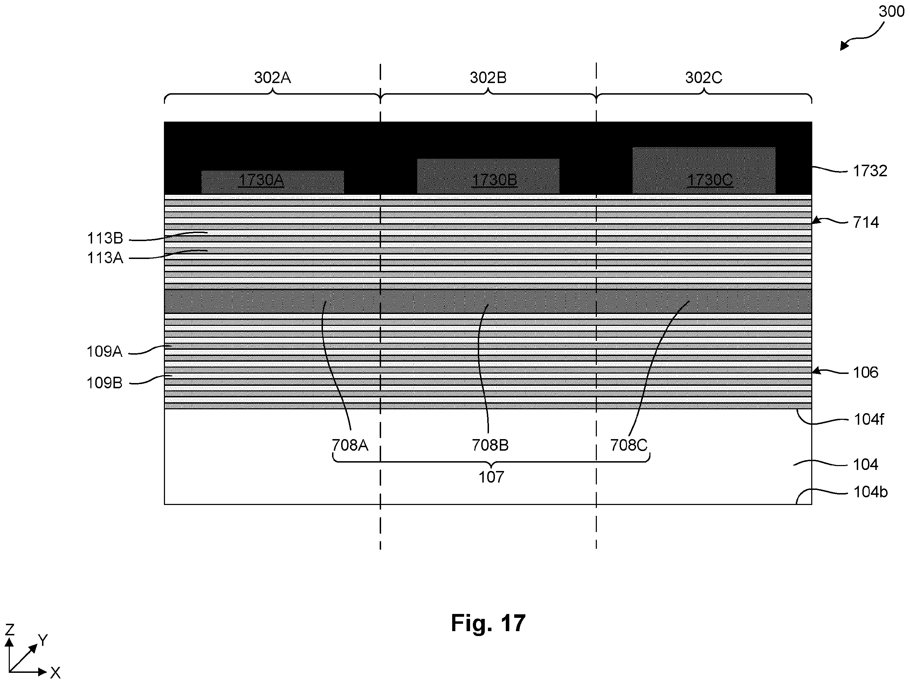

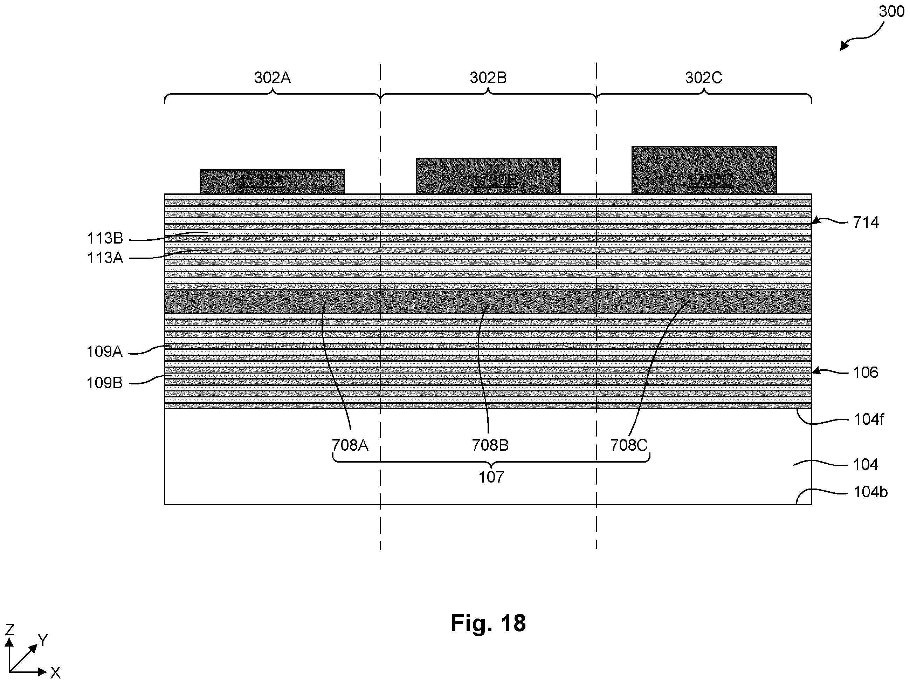

Referring to Fig. 15, in operation 1520, capping structures are formed on the layered structure. For example, as described with reference to Figs. 16-18, capping structures 1730A-1730C are formed on layered structure 714. The formation of capping structures 1730A-1730C can include sequential operations of (i) depositing a polymeric material layer 1630 on layered structure 714, as shown in Fig. 16, (ii) transferring a mold pattern on polymeric material layer 1630 by pressing a mold 1732 on polymeric material layer 1630, as shown in Fig. 17, and (iii) removing mold 1732 to form capping structures 1730A-1730C, as shown in Fig. 18. In some embodiments, capping structures 1730A-1730C can have thicknesses or patterns different from each other.

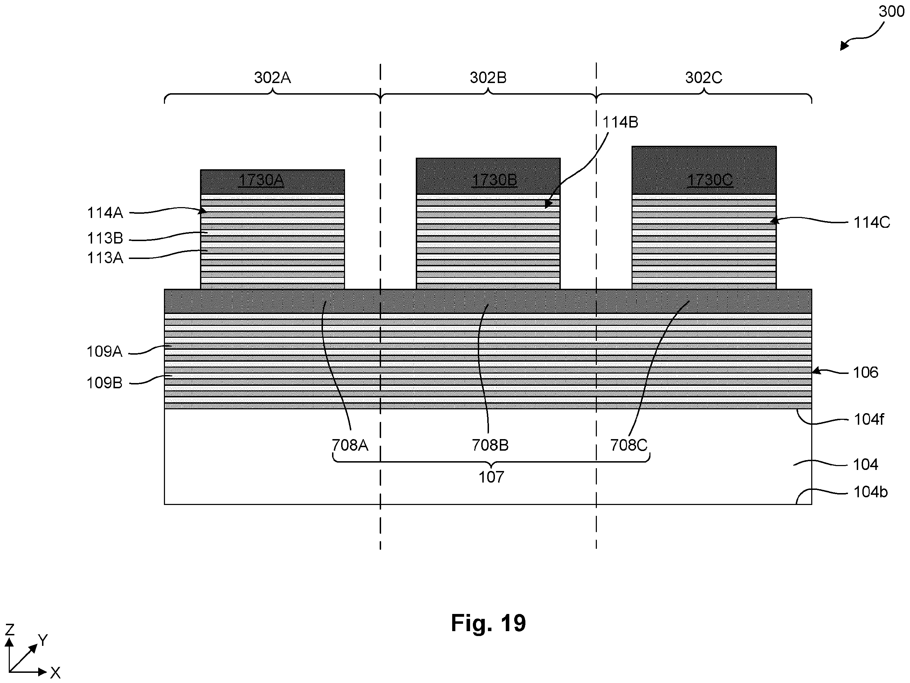

Referring to Fig. 15, in operation 1525, a second reflector is formed on each of the active regions. For example, as shown in Fig. 19, second reflectors 114A-114C are formed on active regions 708A-708C. The formation of second reflectors 114A-114C can include using capping structures 1730A-1730C as mask structures and etching layered structure 714 to form the structure of Fig. 19.

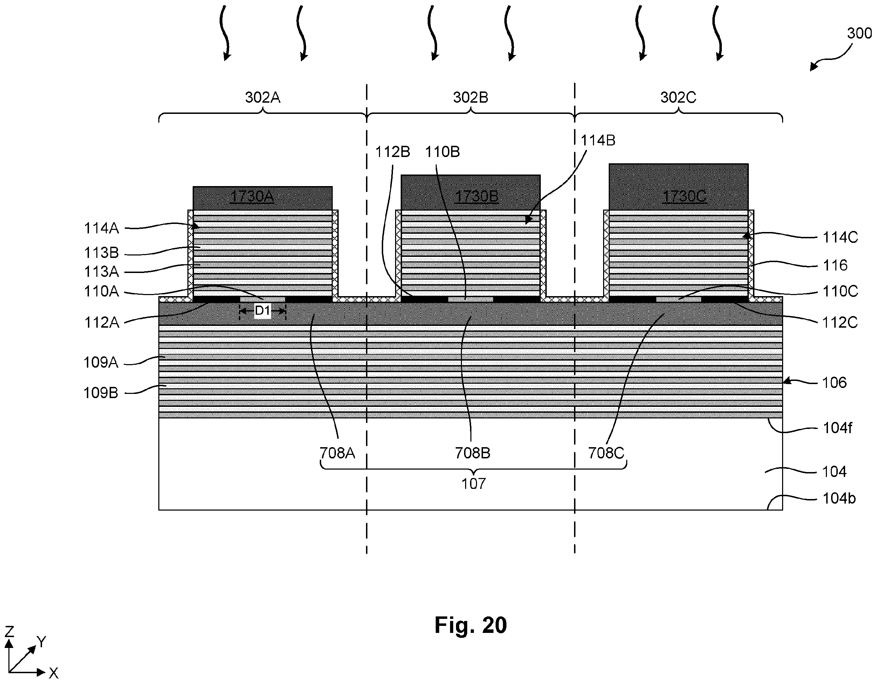

Referring to Fig. 15, in operation 1530, an aperture is formed on each of the active regions. For example, as shown in Fig. 20, apertures 110A-110C is similar to that described in operation 620.

Referring to Fig. 15, in operation 1535, passivation layers are formed around the second reflectors. For example, as shown in Fig. 20, passivation layers 116 are formed around second reflectors 114A-114C. The formation of passivation layer 116 can include sequential operations of (i) depositing an oxide or nitride material layer on the structure of Fig. 19, and (ii) etching portions of the oxide or nitride material layer from capping structures 1730A-1730C to form the structure of Fig. 20.

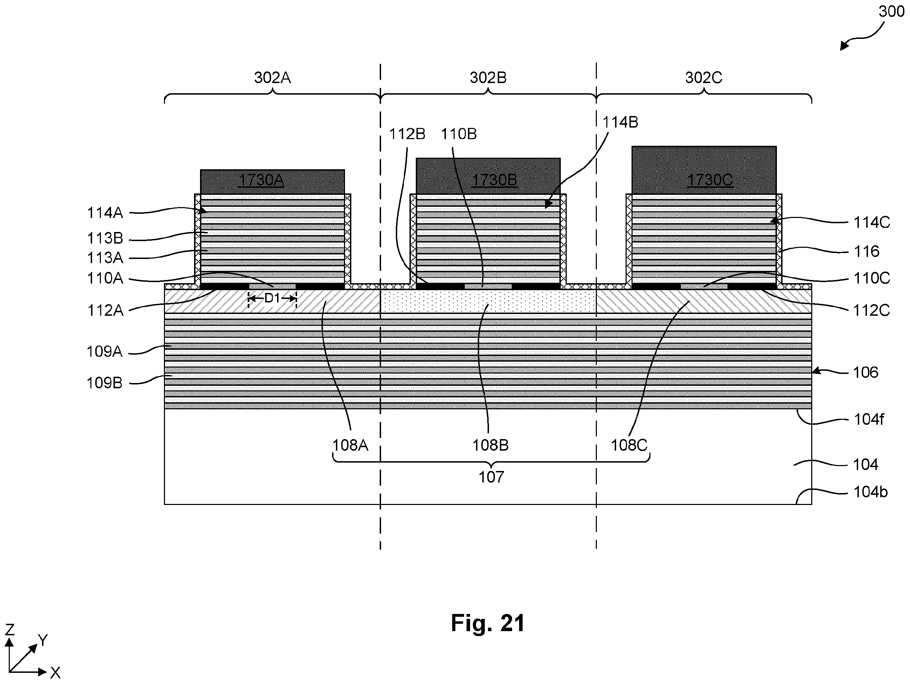

Referring to Fig. 15, in operation 1540, an anneal process is performed. For example, as described with reference to Figs. 20-21, an annealing process can be performed on the structure of Fig. 20 after the formation of passivation layers 116 to convert active regions 708A-708C to active regions 108A-108C, as shown in Fig. 21. Unlike the selective annealing process in operation 630 of Fig. 6, in operation 1535 of Fig. 15, active regions 708A-708C can be annealed at the same time with the same annealing conditions, and the initial primary emission wavelength of active regions 708A-708C can be blue shifted to the first, second, and third primary emission wavelengths of active regions 108A-108C that are shorter than the initial primary emission wavelength and different from each other, as discussed in operation 630. In operation 1535, the selective thermal treatment of active regions 708A-708C is controlled by the different thicknesses of capping structures 1730A-1730C, instead of the different sets of annealing conditions used in operation 630. The different thicknesses of capping structures 1730A-1730C vary the thermal exposure conditions of active regions 708A-708C because the amount of heat transfer to active regions 708A-708C through capping structures 1730A-1730C will be different due to the different thicknesses of capping structures 1730A-1730C.

In some embodiments, the annealing process can be performed on back side 104b of substrate 104, instead of performing on the front side of the structure, as shown in Fig. 20.

Referring to Fig. 15, in operation 1545, capping structures are removed. For example, capping structures 1730A-1730C can be removed from the structure of Fig. 21 by an etching process. As described below, this operation can be optional and may not be performed if grating structures 322A-322C are formed in operation 1520 instead of capping structures 1730A-1730C.

Referring to Fig. 15, in operation 1550, contacts are formed on the second reflectors and on a second side of the substrate. In some embodiments, similar to operation 635, first contacts 118A-118C can be formed on second reflectors 114A-114C and second contacts 120A-120C can be formed on back side 104b of substrate 104 to form the structure of Fig. 14.

In some embodiments, operation 1550 may not be performed if first contacts 3318A-3318C are formed between second reflectors 114A-114C and active regions 108A-108C-rather than first contacts 118A-118C being formed on second reflectors 114A-114C, as shown in Fig. 33. Further, if second contacts 3320A-3320C are formed between first reflector 106 and active regions 108A-108C-rather than second contacts 120A-120C being formed on substrate 104, as shown in Fig. 33. In some embodiments, the formation of first contacts 3318A-3318C can include epitaxially growing a p-type semiconductor material layer, such as p-type GaAs layer on first reflector 106 in operation 1505, and/or the formation of second contacts 3320A-3320C can include epitaxially growing an n-type semiconductor layer, such as n-type GaAs layer on light emission layer 107 in operation 1510.

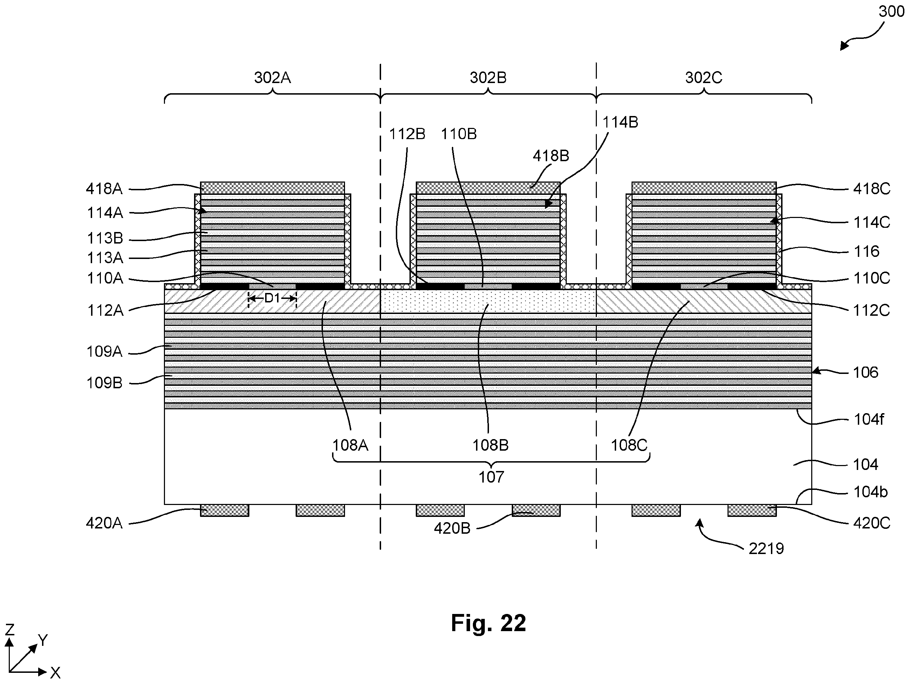

In some embodiments, instead of forming first contacts 118A-118C and second contacts 120A-120C in operation 1550, first contacts 418A-418C can be formed as electrical contacts on second reflectors 114A-114C, and second contacts 420A-420C can be formed as annular-shaped electrical contacts on back side 104b of substrate 104 with openings 2219 aligned with apertures 110A-110C, as shown in Fig. 22.

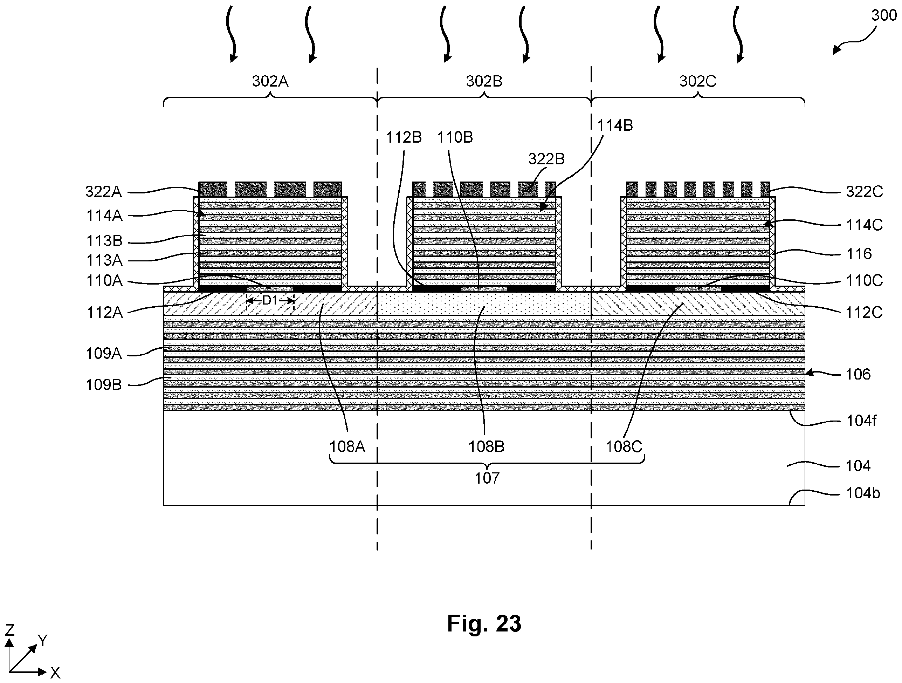

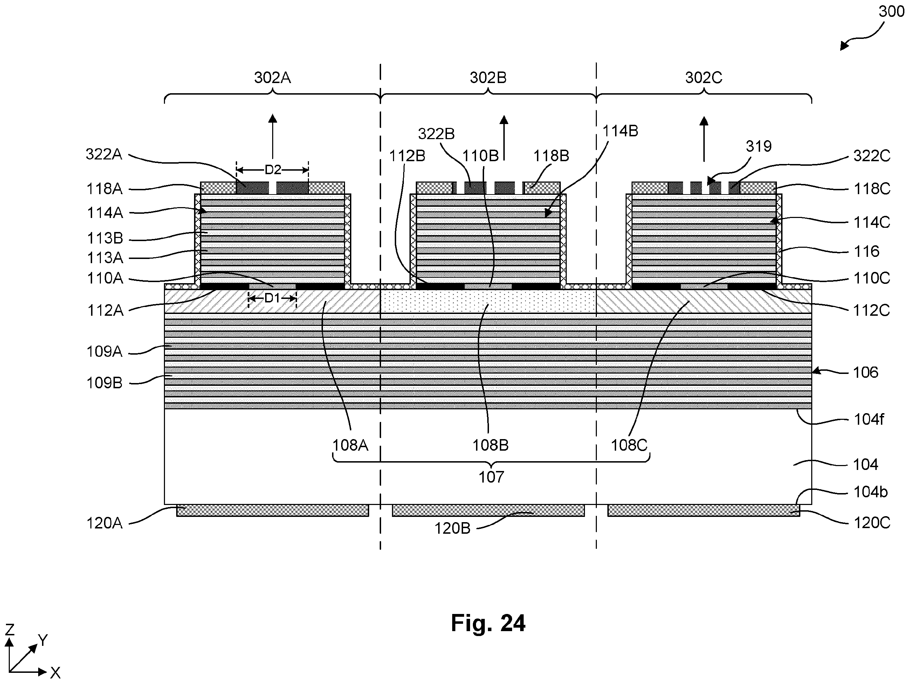

In some embodiments, in operation 1520, instead of forming capping structures 1730A-1730C, grating structures 322A-322C can be formed by transferring a mold pattern on polymeric material layer 1630 to form the structure of Fig. 23. Similar to capping structures 1730A-1730C, the use of grating structures 322A-322C with periodic patterns different from each other can allow active regions 708A-708C to be annealed at the same time with the same annealing conditions, as shown in Fig. 23. If grating structures 322A-322C are formed in operation 1520, operation 1545 may not be performed. Following the annealing process in operation 1540, first contacts 118A-118C can be formed on second reflectors 114A-114C and second contacts 120A-120C can be formed on back side 104b of substrate 104 to form the structure of Fig. 24.

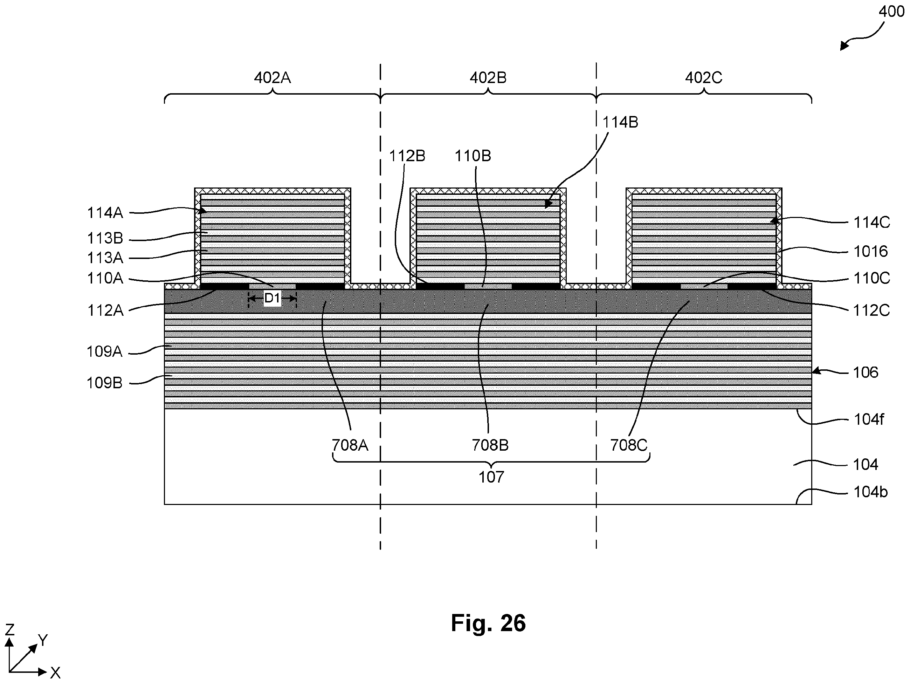

Fig. 25 is a flow diagram of an example method 2500 for fabricating MWLE semiconductor device 400 with an array of back-emitting VCSELs 402A-402C shown in Fig. 4, according to some embodiments. For illustrative purposes, the operations illustrated in Fig. 25 will be described with reference to the example fabrication process for fabricating MWLE semiconductor device 400 as illustrated in Figs. 26-32. Figs. 26-32 are cross-sectional views of MWLE semiconductor device 400 at various stages of fabrication, according to some embodiments. Operations can be performed in a different order or not performed depending on specific applications. It should be noted that method 2500 may not produce a complete MWLE semiconductor device 400. Accordingly, it is understood that additional processes can be provided before, during, and after method 2500, and that some other processes may only be briefly described herein. Elements in Figs. 26-32 with the same annotations as elements in Figs. 1, 3-4, 7-14, and 16-24 are described above.

Referring to Fig. 25, operations 2505-2525 are similar to operations 605-625 of Fig. 6, respectively, and form the structure of Fig. 26.

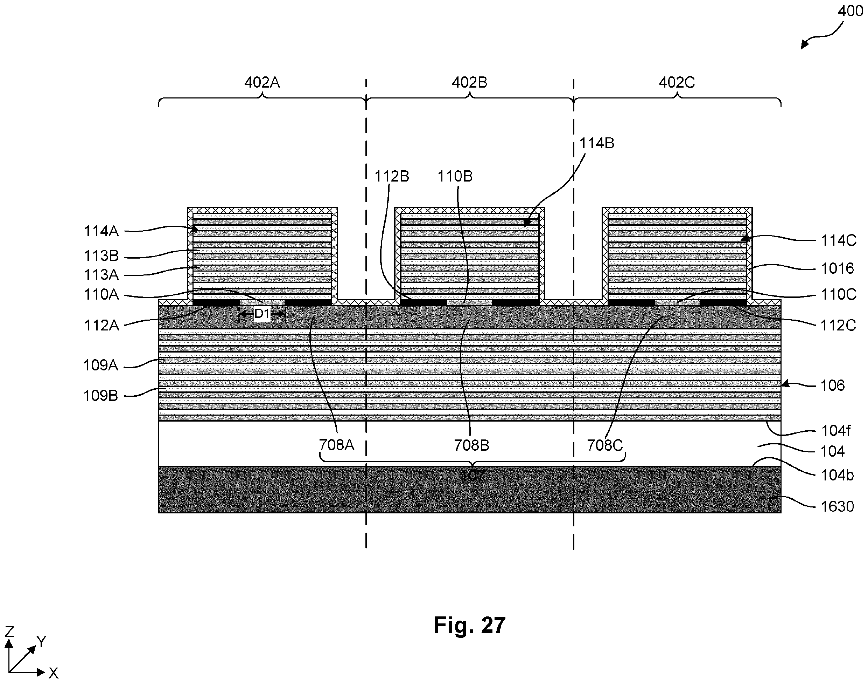

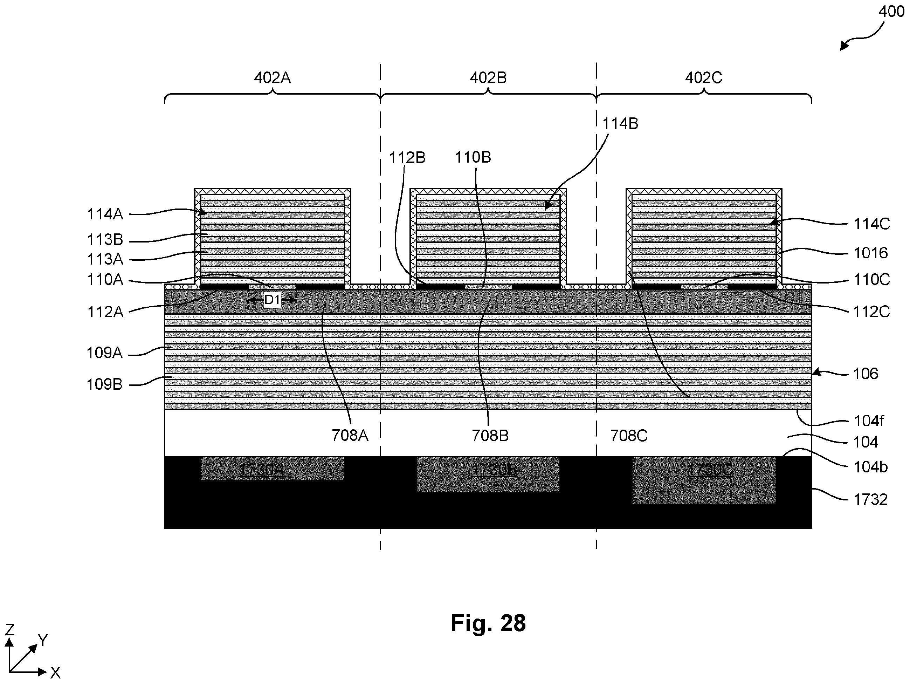

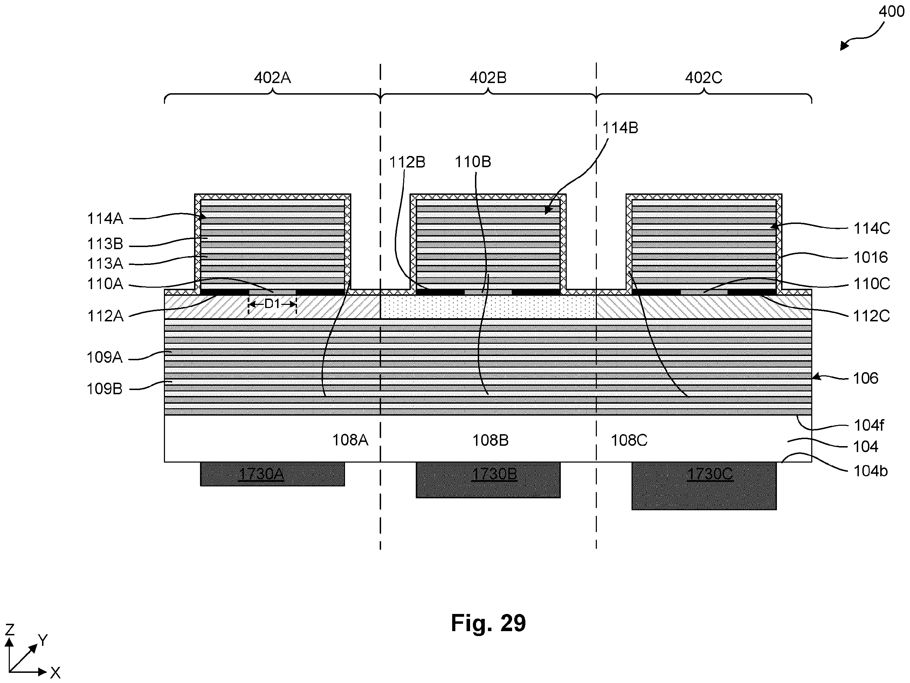

Referring to Fig. 25, in operation 2530, capping structures are formed on a second side of substrate. For example, as described with reference to Figs. 27-29, capping structures 1730A-1730C are formed on back side 104b of substrate 104. The formation of capping structures 1730A-1730C can include sequential operations of (i) thinning down substrate 104 from back side 104b, (ii) depositing polymeric material layer 1630 on back side 104b of substrate, as shown in Fig. 27, (iii) transferring a mold pattern on polymeric material layer 1630 by pressing mold 1732 on polymeric material layer 1630, as shown in Fig. 28, and (iv) removing mold 1732 to form capping structures 1730A-1730C, as shown in Fig. 29.

Referring to Fig. 25, in operation 2535, an annealing process is performed. Similar to operation 1540 of Fig. 15, the annealing process in operation 2535 is performed on the structure formed (not shown) after removing mold 1732 to convert active regions 708A-708C to active regions 108A-108C, as shown in Fig. 29. In some embodiments, the annealing process can be performed on the back side of the structure, i.e., the side with capping structures 1730A-1730C or on the front side of the structure, i.e., the side with passivation layer 1016.

Referring to Fig. 25, in operation 2540, capping structures are removed. For example, capping structures 1730A-1730C can be removed from the structure of Fig. 29 by an etching process. As described below, this operation can be optional and may not be performed if grating structures 422A-422C are formed in operation 2530 instead of capping structures 1730A-1730C.

Referring to Fig. 25, in operation 2545, contacts are formed on the second reflectors and on a second side of the substrate. In some embodiments, similar to operation 635 of Fig. 6, first contacts 118A-118C can be formed on second reflectors 114A-114C and second contacts 120A-120C can be formed on back side 104b of substrate 104 to form the structure of Fig. 14.

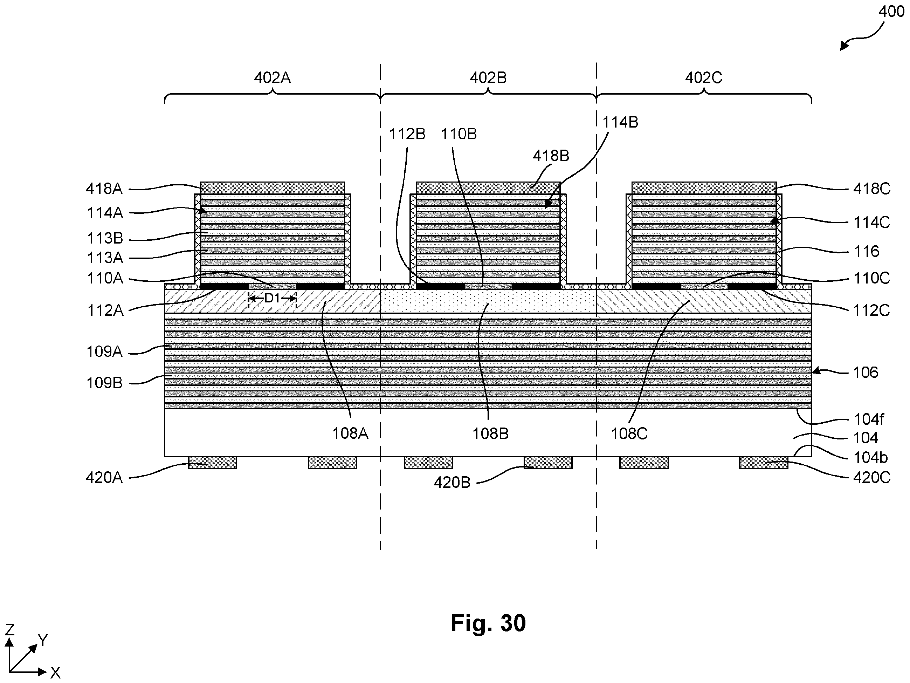

In some embodiments, instead of forming first contacts 118A-118C and second contacts 120A-120C in operation 2545, first contacts 418A-418C can be formed as electrical contacts on second reflectors 114A-114C and second contacts 420A-420C can be formed as annular-shaped electrical contacts on back side 104b of substrate 104 with openings 2219 aligned with apertures 110A-110C, as shown in Fig. 30.

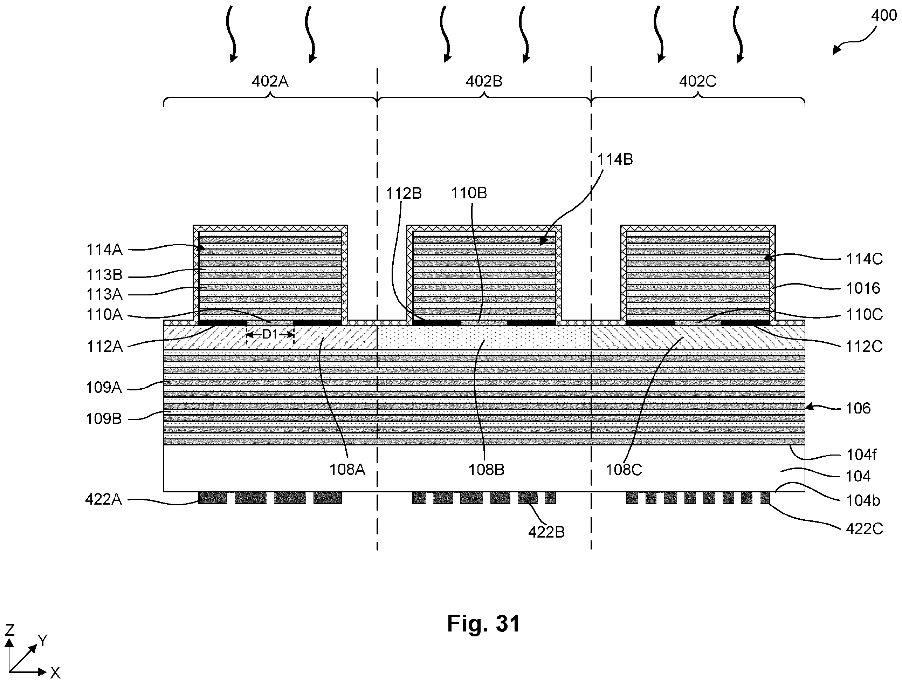

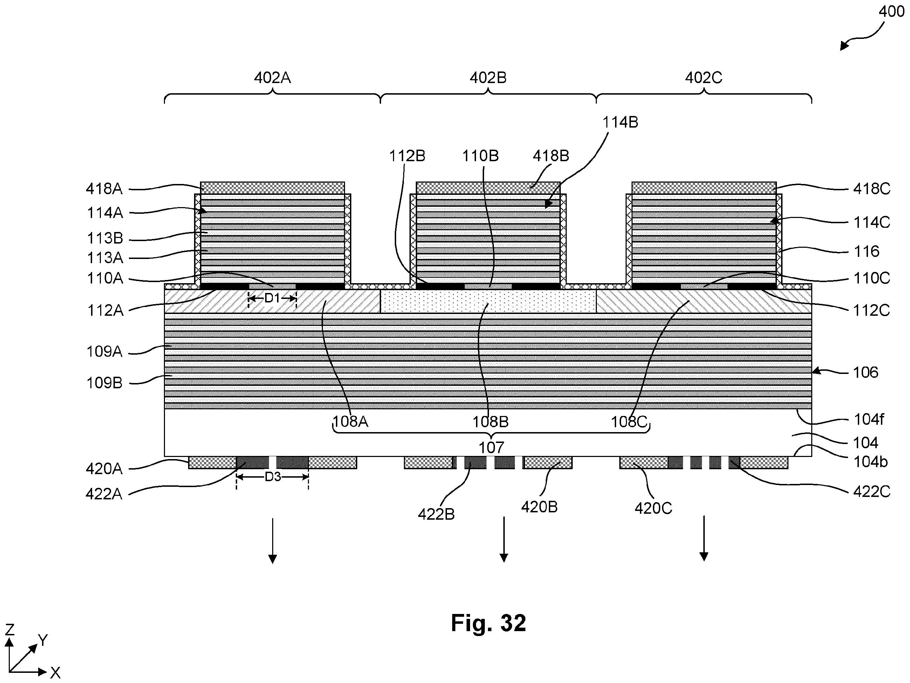

In some embodiments, in operation 2530, instead of forming capping structures 1730A-1730C, grating structures 422A-422C can formed by transferring a mold pattern on polymeric material layer 1630 to form the structure of Fig. 31. Similar to capping structures 1730A-1730C, the use of grating structures 422A-422C with periodic patterns different from each other can allow active regions 708A-708C to be annealed at the same time with the same annealing conditions, as shown in Fig. 31. Though Fig. 31 illustrates the annealing process being performed on the back side of the structure, i.e., the side with grating structures 422A422-C, the annealing process can be performed on the front side of the structure, i.e., the side with passivation layer 1016, according to some embodiments. If grating structures 422A-422C are formed in operation 2530, operation 2540 may not be performed. Following the annealing process in operation 2535, first contacts 418A-418C can be formed on second reflectors 114A-114C and second contacts 420A-420C can be formed on back side 104b of substrate 104 to form the structure of Fig. 32.

The foregoing disclosure outlines features of several embodiments so that those skilled in the art may better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the scope of the present disclosure, and that they may make various changes, substitutions, and alterations herein without departing from the scope of the present disclosure.

## Claims

1. A semiconductor device (100, 200, 300, 400, 500), comprising:
a substrate (104);
a first reflector (106) on the substrate (104);
a light emission layer (107) on the first reflector (106), wherein the light emission layer (107) comprises active regions (108A-C), and wherein each of the active regions (108A-C) comprises a primary emission wavelength different from each other;
second reflectors (114A-C) on corresponding active regions (108A-C); and
apertures (110A-C) on corresponding active regions (108A-C).

2. The semiconductor device of claim 1, wherein the light emission layer (107) comprises a III-V compound semiconductor material with a nitrogen atom concentration between about 0 % and about 5 % of the group V materials.

3. The semiconductor device of any one of claims 1-2, wherein the light emission layer (107) comprises a III-V compound semiconductor material with an indium atom concentration between about 0 % and about 20 % of the group III materials.

4. The semiconductor device of any one of claims 1-3, wherein each of the second reflectors (114A-C) comprises a stack of dielectric layers; and
wherein the stack of dielectric layers comprises a metal oxide, a metal sulfide, a metal halide, an oxynitrides, or a combination thereof.

5. The semiconductor device of any one of claims 1-4, wherein each of the apertures (110A-C) comprises a III-V compound semiconductor material with an aluminum atom concentration between about 80 % and about 100 % of the group III materials.

6. The semiconductor device of any one of claims 1-5, further comprising insulating structures on corresponding second reflectors (114A-C), wherein the insulating structures are substantially aligned with corresponding apertures (110A-C).

7. The semiconductor device of any one of claims 1-6, further comprising grating structures (322A-C, 422A-C) on corresponding second reflectors (114A-C), wherein the grating structures (322A-C, 422A-C) have periodic patterns different from each other, and wherein the grating structures (322A-C, 422A-C)comprise a polymeric material.

8. The semiconductor device of any one of claims 1-7, further comprising:
insulating structures disposed on the substrate (104); and
contact structures surrounding corresponding insulating structures.

9. The semiconductor device of any one of claims 1-8 further comprising:
grating structures (322A-C, 422A-C) disposed on the substrate (104); and
contact structures surrounding corresponding grating structures (322A-C, 422A-C).

10. A method (600, 1500), comprising:
forming (605, 1505) a bottom reflector on a first side of a substrate;
forming (610, 1510) a light emission layer with first and second active regions on the bottom reflector, wherein the first and second active regions comprise an initial primary emission wavelength;
forming (615, 1525) first and second top reflectors on the first and second active regions, respectively;
forming (620, 1530) first and second apertures on the first and second active regions, respectively;
performing (630, 1540) an anneal process on the first and second active regions to shift the initial primary emission wavelength to first and second primary emission wavelengths, respectively, wherein the first and second primary emission wavelengths are different from each other.

11. The method of claim 10, wherein performing the anneal process on the first and second active regions comprises:
selectively annealing the first active region at a first annealing condition to shift the initial primary emission wavelength of the first active region to the first primary emission wavelength; and
selectively annealing the second active region at a second annealing condition to shift the initial primary emission wavelength of the second active region to a second primary emission wavelength, wherein the first and second annealing conditions are different from each other.

12. The method of any one of claims 10-11, wherein performing an anneal process on the first and second active regions comprises performing a laser anneal process.

13. The method of any one of claims 10-12, further comprising:
forming (1520) first and second capping structures on the first and second top reflectors, wherein thicknesses of the first and second capping structures are different from each other.

14. The method of any one of claims 10-12, further comprising:
forming first and second grating structures on the first and second top reflectors, wherein periodic patterns of the first and second grating structures are different from each other.

15. The method of any one of claims 10-12, further comprising:
forming first and second capping structures on a second side of the substrate, wherein thicknesses of the first and second capping structures are different from each other; and/or
forming first and second grating structures on a second side of the substrate, wherein periodic patterns of the first and second grating structures are different from each other.
